# EUROPEAN PATENT APPLICATION

(11) **EP 4 729 654 A2**
(43) Date of publication of application: **22.04.2026**
(21) Application number: 25204323.7
(22) Date of filing: 24.09.2025
(51) Int. Cl.: C23C 16/32, C23C 16/40, C23C 16/455

(54) **COMPOSITIONS FOR FORMING A CARBON DOPED SILICON CONTAINING FILM AND METHODS FOR FORMING SAID COMPOSITIONS AND METHODS AND SYSTEMS FOR USING SAID COMPOSITIONS**

(30) Priority: 27.09.2024 US 202463700240 P
(71) Applicant: ASM IP Holding B.V., 1322 AP Almere (NL)
(72) Inventor: ROMERO, Patricio Eduardo, 1322 AP Almere (NL); LIIMATAINEN, Ville, 1322 AP Almere (NL); PORE, Viljami J., 1322 AP Almere (NL); VERVUURT, René Henricus Jozef, 1322 AP Almere (NL); MARIAMPILLAI, Brian, 1322 AP Almere (NL)
(74) Representative: V.O.

(57) **Abstract**

A film forming composition is provided. The film forming composition comprises a silicon precursor having a structure according to general Formula (1): 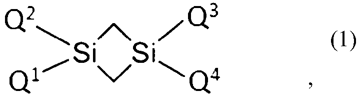 wherein, Q¹ is a substituent selected from an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent independently selected from a hydrogen atom, a C₁-C₆ alkyl group, and the substituent group of Q¹. Methods for forming the film forming composition and methods and systems for using the film forming composition to deposit a carbon doped silicon containing film on a substrate are also provided.

## Description

### CROSS-REFERENCE TO RELATED APPLICATION(S)

This Application claims the benefit of U.S. Provisional Application 63/700,240 filed on September 27, 2024, the entire contents of which are incorporated herein by reference.

### FIELD

The present disclosure generally relates to the processing of semiconductor substrates. More specifically, the disclosure relates to compositions that are useful for forming a carbon doped silicon containing film and methods and systems for using the composition to form a carbon doped silicon containing film on a surface of a substrate.

### BACKGROUND

Silicon oxycarbide (SiOC) is a promising low-κ replacement material for certain silicon oxide and silicon nitride layers in next generation semiconductor devices. The carbon content of the SiOC film reduces the dielectric constant by increasing the porosity and/or the polarization. The composition of the film should be optimized to yield a sufficiently low dielectric constant while maintaining the required thermal and mechanical properties of the film for the specific application. Furthermore, such low-κ layers must be able to be formed using chemical vapor deposition (CVD) methods that provide conformal films with precise thickness control at temperatures that are consistent with the fabrication of device structures and, in some applications, while maintaining a high throughput.

Silicon oxycarbide films are generally formed using plasma-based CVD processes at relatively low temperature to reduce the thermal budget in fabricating the device. The selection of the chemical precursor(s) that are used in the deposition method can greatly influence both the process conditions and the material properties of the resulting layer. Finding improved low-κ material precursors for CVD processes is an ongoing effort. In this regard, the present disclosure generally relates to precursor compositions and methods and systems for using said precursor compositions to form carbon doped silicon containing films that meet many of the above listed requirements.

Any discussion, including discussion of problems and solutions, set forth in this section has been included in this disclosure solely for the purpose of providing a context for the present disclosure. Such discussion should not be taken as an admission that any of the information was known at the time the invention was made or otherwise constitutes prior art.

### SUMMARY

This summary may introduce a selection of concepts in a simplified form, which may be described in further detail below. This summary is not intended to necessarily identify key features or essential features of the claimed subject matter, nor is it intended to be used to limit the scope of the claimed subject matter.

An aspect of the present disclosure relates to a film forming composition that is configured for and/or suitable for forming a carbon doped silicon containing film. The film forming composition comprises a silicon precursor having a structure according to general Formula (1): 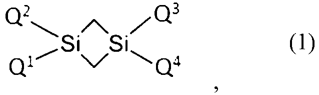 wherein Q¹ is a substituent selected from an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent independently selected from a hydrogen atom, a C₁-C₆ alkyl group, and the same substituent group of Q¹.

In some embodiments, the substituent group of Q¹ is an acetoxy group. In some of these embodiments, the substituent group of Q¹ and the substituent group of Q³ are both an acetoxy group.

In some embodiments, the substituent group of Q¹ is an acryloyloxy group. In some of these embodiments, the substituent group of Q¹ and the substituent group of Q³ are both an acryloyloxy group. The acryloyloxy group may be selected from an acryloyloxy group or a methacryloyloxy group.

In some embodiments, the substituent group of Q¹ is a C₁ to C₆ alkoxy group. In some of these embodiments, the substituent group of Q¹ and the substituent group of Q³ are both a C₁ to C₆ alkoxy group. The C₁ to C₆ alkoxy group may be selected from the group consisting of a methoxy group, an ethoxy group, a n-propoxy group, an iso-propoxy group, and a butoxy group.

In some embodiments, the substituent group of Q¹ is a silyloxy group. In some of these embodiments, the substituent group of Q¹ and the substituent group of Q³ are both a silyloxy group. The silyloxy group may be a trimethylsilyloxy group.

In some embodiments, the substituent group of Q¹ is a germyloxy group. In some of these embodiments, the substituent group of Q¹ and the substituent group of Q³ are both a germyloxy group. The germyloxy group may be a trimethylgermyloxy group.

In some embodiments, the substituent group of Q¹ is a phosphonooxy group. In some of these embodiments, the substituent group of Q¹ and the substituent group of Q³ are both a phosphonooxy group. The phosphonooxy group may be a dimethylphosphonooxy group.

In some embodiments, the substituent group of Q¹ is an alkyl amine group. In some of these embodiments, the substituent group of Q¹ and the substituent group of Q³ are both an alkyl amine group. The alkyl amine group may be selected from the group consisting of a dimethylamine group, a diethylamine group, and a di-isopropylamine group.

In some embodiments, the substituent groups Q¹ and Q³ are dependently selected from an acetoxy group, an acryloyloxy group, a C₁ to C₆ alkoxy group, a silyloxy group, a germyloxy group, a phosphonooxy group, and an alkyl amine group; and the substituent groups Q² and Q⁴ are dependently selected from a hydrogen atom and a C₁-C₆ alkyl group.

In some embodiments, the silicon precursor is selected from the group consisting of 1,3-diacetoxy-1,3-disilacyclobutane, 1,3-diacetoxy-1,3-dimethyl-1,3-disilacyclobutane, 1,3-diacryloyloxy-1,3-disilacyclobutane, 1,3-diacryloyloxy-1,3-dimethyl-1,3-disilacyclobutane, 1,3-dimethyacryloyloxy-1,3-disilacyclobutane, 1,3-dimethyacryloyloxy-1,3-dimethyl-1,3-disilacyclobutane, 1,3-diethoxy-1,3-disilacyclobutane, 1,3-diethoxy-1,3-dimethyl-1,3-disilacyclobutane, 1,3-bis(trimethylsilyloxy)-1,3-disilacyclobutane, 1,3-bis(trimethylsilyloxy)-1,3-dimethyl-1,3-disilacyclobutane, 1,3-bis(trimethylgermyloxy)-1,3-disilacyclobutane, 1,3-bis(trimethylgermyloxy)-1,3-dimethyl-1,3-disilacyclobutane, 1,3-bis(dimethylphosphonooxy)-1,3-disilacyclobutane, 1,3-bis(dimethylphosphonooxy)-1,3-dimethyl-1,3-disilacyclobutane, 1,3-bis(diethylamine)-1,3-disilacyclobutane, and 1,3-bis(diethylamine)-1,3-dimethyl-1,3-disilacyclobutane.

In some embodiments, the film forming composition is isomerically enriched. In some embodiments, at least 85% of the silicon precursor is in the cis-isomer form or at least 85% of the silicon precursor is in the trans-isomer form. In some of these embodiments, at least 85% of the silicon precursor is in the cis-isomer form, or at least 90% of the silicon precursor is in the cis-isomer form, or at least 95% of the silicon precursor is in the cis-isomer form, or at least 97% of the silicon precursor is in the cis-isomer form, or at least 98% of the silicon precursor is in the cis-isomer form, or at least 99% of the silicon precursor is in the cis-isomer form, or at least 99.5% of the silicon precursor is in the cis-isomer form. In some other of these embodiments, at least 85% of the silicon precursor is in the trans-isomer form, or at least 90% of the silicon precursor is in the trans-isomer form, or at least 95% of the silicon precursor is in the trans -isomer form, or at least 97% of the silicon precursor is in the trans-isomer form, or at least 98% of the silicon precursor is in the trans-isomer form, or at least 99% of the silicon precursor is in the trans-isomer form, or at least 99.5% of the silicon precursor is in the trans-isomer form.

In some embodiments, the film forming composition has a purity of at least about 90 wt. % based on the weight of the silicon precursor. In some embodiments, the film forming composition has a purity of at least about 95 wt. %, or a purity of at least about 97 wt. %, or a purity of at least about 98 wt. %, or a purity of at least about 99 wt. %, or a purity of at least about 99.5wt. %, or a purity of at least about 99.9 wt. %.

Another aspect of the present disclosure relates to a method for forming the film forming composition comprising the silicon precursor described in any of the above paragraphs. The method comprises providing a halogen substituted 1,3-disilacyclobutane reactant comprising at least one halogen substituent; and exchanging the at least one halogen substituent of the halogen substituted 1,3-disilacyclobutane reactant with the substituent group of Q¹ to form the silicon precursor. The step of exchanging the at least one halogen substituent of the halogen substituted 1,3-disilacyclobutane reactant may comprise contacting the halogen substituted 1,3-disilacyclobutane reactant with an organic metal salt, wherein the organic metal salt comprises the Q₁ substituent group. The Q¹ substituent group may be selected from the group consisting of an acetoxy group, an acryloyloxy group, a C₁ to C₆ alkoxy group, a silyloxy group, a germyloxy group, a phosphonooxy group, and an alkyl amine group.

In some of these embodiments, the organic metal salt has a general structure of M(Q¹)ₙ, wherein (i) M is a Group I metal and n is an integer equal to 1 or (ii) M is a Group II metal and n is an integer equal to 2.

In some embodiments, the organic metal salt is selected from the group consisting of a metal acetate, a metal acrylate, a metal oxide, a metal phosphate, a metal siloxide, a metal germyloxide, and a metal amide.

In some embodiments, the halogen substituted 1,3-disilacyclobutane reactant is selected from the group consisting of 1-chloro-1,3-disilacyclobutane, 1-chloro-1,3,3-trimethyl-1,3-disilacyclobutane, 1,3-dichloro-1,3-disilacyclobutane, 1,3-dichloro-1,3-dimethyl-1,3-disilacyclobutane, 1,1,3,3-tetrachloro-1,3-disilacyclobutane, 1-bromo-1,3-disilacyclobutane, 1- bromo-1,3,3-trimethyl-1,3-disilacyclobutane, 1,3-dibromo-1,3-disilacyclobutane, 1,3-dibromo-1,3-dimethyl-1,3-disilacyclobutane, and 1,1,3,3-tetrabromo-1,3-disilacyclobutane.

In some embodiments, the method further comprises separating the silicon precursor from a metal halide salt.

In certain embodiments, the step of providing the halogen substituted 1,3-disilacyclobutane reactant comprises stereoselectively forming a 1,3-disilacyclobutane intermediate; and reacting the 1,3-disilacyclobutane intermediate to form the halogen substituted 1,3-disilacyclobutane reactant. In some of these embodiments, the 1,3-disilacyclobutane intermediate is a second 1,3-disilacyclobutane intermediate, and the method further comprises stereoselectively forming a first 1,3-disilacyclobutane intermediate; and forming the second 1,3-disilacyclobutane intermediate from the first 1,3-disilacyclobutane intermediate.

In some embodiments, the silicon precursor is formed such that at least 85% of the silicon precursor is in the cis-isomer form or such that at least 85% of the silicon precursor is in the trans-isomer form. In some of these embodiments, at least 85% of the silicon precursor is in the cis-isomer form, or at least 90% of the silicon precursor is in the cis-isomer form, or at least 95% of the silicon precursor is in the cis-isomer form, or at least 97% of the silicon precursor is in the cis-isomer form, or at least 98% of the silicon precursor is in the cis-isomer form, or at least 99% of the silicon precursor is in the cis-isomer form, or at least 99.5% of the silicon precursor is in the cis-isomer form. In some other of these embodiments, at least 85% of the silicon precursor is in the trans-isomer form, or at least 90% of the silicon precursor is in the trans-isomer form, or at least 95% of the silicon precursor is in the trans-isomer form, or at least 97% of the silicon precursor is in the trans-isomer form, or at least 98% of the silicon precursor is in the trans-isomer form, or at least 99% of the silicon precursor is in the trans-isomer form, or at least 99.5% of the silicon precursor is in the trans-isomer form.

Another aspect of the present disclosure relates to a vapor delivery vessel comprising the film forming composition comprising the silicon precursor described in any of the related paragraphs above. The vapor delivery vessel comprises an outer wall that encloses a cavity for storing the film forming composition and a gas outlet for allowing a vapor of the film forming composition to exit the cavity.

In some embodiments, the vapor delivery vessel further comprises a gas inlet and a conduit that extends into the cavity to a fixed point. The conduit may extend into the cavity and into the film forming composition for passing a carrier gas through the film forming composition. Alternatively, the conduit may extend into the cavity to a point that is above the film forming for passing a carrier gas over the surface of the film forming composition.

In some embodiments, the vapor delivery vessel further comprises a probe member. The probe member may comprise one or more temperature sensors and/or one or more level sensors and one or more pressure sensors.

In some embodiments, the outer wall and the cavity of the vapor delivery vessel are formed from stainless steel.

Another aspect of the present disclosure relates to a method for forming a carbon-doped silicon containing film using the film forming composition comprising the silicon precursor described in any of the related paragraphs above. The method comprises providing a substrate in a reaction space; and exposing a surface of the substrate to a vapor of the film forming composition. In some embodiments, the method further comprises exposing the surface of the substrate to a co-reactant.

In some embodiments, the method for forming a carbon-doped silicon containing film comprises performing one or more deposition cycles of a cyclic deposition process comprising exposing a surface of the substrate to a film forming composition; and exposing the surface of the substrate to a co-reactant, thereby forming a carbon-doped silicon containing film on the surface of the substrate. The exposing steps may be repeated one or more n times. The cyclic deposition process may include one or more of an ALD process and a cyclic CVD process.

In some embodiments, the co-reactant comprises a plasma species. The plasma species may be one or more of a hydrogen plasma species, a noble gas plasma species, a nitrogen plasma species, and an oxygen plasma species. In some of these embodiments, the co-reactant is a plasma. In some of these embodiments, the method further comprises exposing the surface of the substrate to a plasma. The plasma may be one or more of a hydrogen plasma, a noble gas plasma, a nitrogen plasma, and an oxygen plasma. In some embodiments the plasma is one or more of a hydrogen plasma and a noble gas plasma.

In certain embodiments, the co-reactant is free of an oxygen plasma species. In some of these embodiments, the surface of the substrate is not exposed to an oxygen plasma or an oxygen plasma species.

In certain embodiments, the surface of the substrate is exposed to a direct plasma. In certain other embodiments, the surface of the substrate is exposed to a remote plasma.

In some embodiments, the steps of exposing the surface of the substrate with the vapor of the film forming composition and exposing the surface of the substrate to the co-reactant occurs sequentially. In some other embodiments, the steps of exposing the surface of the substrate with the vapor of the film forming composition and exposing the surface of the substrate to the co-reactant at least partially overlap.

In some embodiments, the reaction space is purged after one or more of the exposing of the surface of the substrate to the vapor of the film forming composition and the exposing of the surface of the substrate to the co-reactant.

In some embodiments, the method further comprises maintaining a temperature of the substrate at no more than about 450 °C during one or both of the exposing steps. The temperature of the substrate may be maintained at least about 100 °C and no more than about 400 °C, or at least about 100 °C and no more than about 300 °C, or at least about 100 °C and no more than about 250 °C.

Another aspect of the present disclosure relates to a system for forming a carbon doped silicon containing film using the film forming composition comprising the silicon precursor described in any of the related paragraphs above, according to the method described in any of the related paragraphs above. The system may comprise a reaction space for accommodating a substrate and a means for exposing a surface of the substrate to a vapor of the film forming composition. The system may further comprise a means for exposing the surface of the substrate to a co-reactant and optionally a means for purging the reaction space after one or both of the exposing steps.

In some embodiments, the system comprises: a reaction space for accommodating a substrate; a film forming composition source for providing a vapor of the forming composition in gas communication via a first valve with the reaction space; a co-reactant source for providing a co-reactant in gas communication via a second valve with the reaction space; and a plasma generator.

In some embodiments, the system further comprises a controller operably connected to the first valve, the second valve, and the plasma generator, wherein the controller is configured and programmed to control supplying the film forming composition into the reaction space, supplying the co-reactant into the reaction space, and activating the plasma generator. The controller may be programmed to repeat the various process steps *n* time to deposit a carbon doped silicon containing film on the surface of the substrate.

In some embodiments, the plasma generator comprises a direct plasma unit. In some other embodiments, the plasma generator comprises a remote plasma unit.

In some embodiments, the reaction space comprises one or more heating elements that are in thermal communication with the substrate and one or more thermocouples to measure and maintain a temperature of the substrate at a set temperature. In some of these embodiments, the controller is operably connected to the one or more heating elements and the one or more thermocouples and is configured and programmed to measure and control a temperature of the at least one heating element to maintain a temperature of the substrate at a set temperature.

In some embodiments, the film forming composition source comprises a vapor delivery vessel that comprises the film forming composition.

Another aspect of the present disclosure relates to a carbon-doped silicon film formed using the film forming composition comprising the silicon precursor described in any of the related paragraphs above, and further formed using the method and the system described in any of the related paragraphs above.

In some of embodiments, the carbon-doped silicon film comprises the silicon precursor and/or a portion or fragment of the silicon precursor.

In some embodiments, the carbon-doped silicon containing film has a carbon content of at least about 5 at. % and no more than about 50 at. %, or at least about 10% and no more than about 50%, or at least about 20% and no more than about 50%.

In some embodiments, the carbon-doped silicon containing film has a dielectric constant (κ) of less than about 4.2, or less than about 4.0, or less than about 3.8, or less than about 3.5, or less than about 3.4, or less than about 3.3, or less than about 3.2, or less than about 3.1, or less than about 3.0, or less than about 2.9, or less than about 2.8, or less than about 2.7, or less than about 2.6, or less than about 2.5, or less than about 2.4, or less than about 2.3, or less than about 2.2, or less than about 2.1, or less than about 2.0.

In some embodiments, the carbon-doped silicon containing film has a step coverage of about 80% or more, or about 90% or more. In some of these embodiments, the carbon-doped silicon containing film has a step coverage of about 90% more and less than about 110%, or about 95% or more and less than about 105%.

These and other embodiments will become readily apparent to those skilled in the art from the following detailed description of certain embodiments and with further reference to the attached figures. These embodiments or components thereof may be combined, or they may be applied separate from each other, as applicable, unless otherwise noted. The invention is not limited to any particular embodiments disclosed.

### BRIEF DESCRIPTION OF DRAWINGS

The accompanying drawings constitute part of the specification. The drawings are included to provide a further understanding of the disclosure, and together with the description explain certain principles of the disclosure. The drawings illustrate exemplary embodiments of how the disclosure can be made and used and are not to be construed as limiting the disclosure to only the illustrated and described examples. It will be appreciated that elements in the figures are illustrated for simplicity and clarity and have not necessarily been drawn to scale. The illustrations presented herein are not meant to be actual views of any particular material, structure, or device, but are merely idealized representations that are used to describe embodiments of the disclosure. For example, the dimensions of some of the elements in the figures may be exaggerated relative to other elements to help improve understanding of illustrated embodiments of the present disclosure. Further features and advantages will become apparent from the following, more detailed, description of various aspects, embodiments, and configurations of the disclosure, as illustrated by the drawings referenced below.
FIG. 1 shows an embodiment of a synthetic scheme for preferentially forming the trans-isomer form of the silicon precursor.
FIG. 2 shows another embodiment of a synthetic scheme for preferentially forming the trans-isomer form of the silicon precursor.
FIG. 3 shows an embodiment of a synthetic scheme for preferentially forming the cis-isomer form of the silicon precursor.
FIG. 4 is a process flow diagram of a method for forming a carbon doped silicon containing film according to an embodiment of the disclosure.
FIG. 5 is a schematic presentation of a semiconductor processing system that is suitable for forming a carbon doped silicon containing film according to an embodiment of the disclosure.
FIG. 6 is a perspective view of a vapor delivery vessel according to an embodiment of the disclosure showing the film forming composition stored therein.

### DETAILED DESCRIPTION

The description of embodiments of compositions, methods, and systems provided below is merely exemplary and is intended for purposes of illustration only. The following description is not intended to limit the scope of the disclosure or the claims. Moreover, recitation of multiple embodiments having indicated features is not intended to exclude other embodiments having additional features or other embodiments incorporating different combinations of the stated features. Unless otherwise noted, the exemplary embodiments or components thereof may be combined or may be applied separate from each other. The headings provided herein, if any, are for convenience only and do not necessarily affect the scope or meaning of the claimed invention.

### Definitions

As used herein, "atomic layer deposition", abbreviated as "ALD", refers to a vapor deposition process in which deposition cycles, such as a plurality of consecutive deposition cycles, are conducted in a reaction space (e.g., one or more reaction chambers). Generally, in ALD processes, during each deposition cycle, a precursor is introduced into the reaction space and is adsorbed onto a substrate surface, which may include a previously deposited material from a previous ALD cycle or other materials, forming maximally one monolayer of the precursor that does not readily react with additional excess precursor (i.e., a self-limiting reaction). Thereafter, in some cases, another precursor or a reactant may be introduced into the reaction space to convert the adsorbed precursor to the desired material on the substrate surface. Other reaction steps may be included in the deposition cycle. ALD may occur by a thermal process (thermal ALD), where the reaction(s) are promoted by increasing the temperature of the substrate relevant to ambient temperature; or by a plasma enhanced process (PE-ALD) or radical enhanced process (RE-ALD), where the reaction(s) are promoted through the use of energetic plasma species. ALD, as used herein, may also be meant to include processes designated by related terms, such as chemical vapor atomic layer deposition, atomic layer epitaxy (ALE), molecular beam epitaxy (MBE), gas source MBE, or organometallic MBE, and chemical beam epitaxy when performed with alternating pulses of reactants.

As used herein, "chemical vapor deposition", abbreviated as "CVD", refers to a vapor deposition process in which a film is deposited on a substrate by exposing its surface to one or more gaseous precursors and reactants, which react and/or decompose on the substrate surface to form the film. The precursors and/or reactants can be provided simultaneously to the reaction space, or in partially or completely separated pulses. In some embodiments, the precursors and/or reactants are provided until a layer having a desired thickness is deposited. In some embodiments, a cyclic CVD process can be used with multiple cycles to deposit a thin film having a desired thickness. In cyclic CVD processes, the precursors and/or reactants may be provided to the reaction space in pulses that do not overlap, or that partially or completely overlap. CVD may occur by a thermal process (thermal CVD), where the reaction(s) are promoted by increasing the temperature of the substrate relevant to ambient temperature; or by a plasma enhanced process (PE-CVD), where the reaction(s) are promoted using energetic plasma species.

As used herein, a "cyclic deposition process" refers to a method or a process comprising sequentially introducing precursors and/or reactants into a reaction space to deposit a layer or a film on or over a substrate and includes processing techniques such as ALD, cyclic CVD, and hybrid cyclic deposition processes that include an ALD component and a cyclic CVD component. In preferred embodiments, a cyclic deposition process as disclosed herein refers to an ALD process.

As used herein, a "film" or "layer", which may be used interchangeably, refers to a continuous, substantially continuous, or non-continuous material that extends in a direction perpendicular to a thickness direction to cover at least a portion of a surface. A film may be positioned on a lateral surface and/or on a sidewall of recessed features of a surface. A film can include two-dimensional materials, three-dimensional materials, nanoparticles, partial or full molecular layers, partial or full atomic layers, and/or clusters of atoms or molecules. A film may be built up from one or more non-discernable monolayers or sub-monolayers to produce a uniform or a substantially uniform material, wherein the number of monolayers or sub-monolayers influences the thickness of the film.

As used herein, a "gas" refers to a state of matter consisting of atoms or molecules that have neither a defined volume nor shape. A gas includes vaporized solid and/or liquid and may be referred to as a vapor. A gas may be constituted by a single gas or a mixture of gases, depending on the context.

As used herein, a "precursor" refers to a compound that participates in a chemical reaction to form another compound or element, wherein a portion of the precursor (an element or group within the precursor) is incorporated into the compound or element that results from the chemical reaction. The compound or element that results from the chemical reaction may be a layer and/or a film that is formed on a surface of a substrate.

As used herein, the term "purge" may refer to a procedure in which vapor phase precursors, reactants, and/or vapor phase byproducts are removed from a substrate surface for example by evacuating the reaction space with a vacuum pump and/or by replacing the gas inside a reaction space with an inert or substantially inert gas such as argon or nitrogen.

As used herein, a "reactant" refers to a compound that participates in a chemical reaction to form another compound or element. In some instances, a reactant is a precursor. In other instances, the compound or element that results from the chemical reaction does not contain a portion, or a significant portion, of the reactant (an element or group within the reactant) and therefore the reactant is not a precursor.

As used herein, a "substrate" refers to an underlying material or materials that may be used to form, or upon which, a device, a circuit, a material, or a material layer may be formed. The substrate may be continuous or non-continuous; rigid or flexible; solid or porous; and combinations thereof. The substrate may be in any form, such as, for example, a powder, a sheet, a plate, or a workpiece. Substrates in the form a sheet may extend beyond the bounds of a process/reaction chamber where a deposition process occurs and, in some cases, move through the chamber such that the process continues until the end of the substrate is reached. Substrates in the form of a plate may include wafers in various shapes and sizes. Substrates may be made from semiconductor materials, including, for example, silicon, silicon germanium, silicon oxide, gallium arsenide, gallium nitride, and silicon carbide. A substrate can include one or more layers overlying a bulk material, for example the substrate may include nitrides, for example TiN, oxides, insulating materials, dielectric materials, conductive materials, metals, such as tungsten, ruthenium, molybdenum, cobalt, aluminum, or copper, or other metallic materials, crystalline materials, epitaxial, heteroepitaxial, and/or single crystal materials. The substrate can include various topologies, such as, for example, gaps, recesses, lines, trenches, vias, holes, or spaces between elevated portions, such as fins, and the like formed within or on at least a portion of a layer of the substrate.

As used herein, "step coverage" refers to the growth rate of a layer on a distal end surface of a recess, divided by the growth rate of that layer on a proximal end surface of the recess, expressed as a percentage. Step coverage provides a measure of the conformity of a layer.

As used herein, a "vapor delivery vessel" refers to a vessel that is configured for vapor delivery of a substance that is contained within the vessel. The vapor delivery vessel comprises an outer wall that encloses a cavity for storing and/or holding the substance and a fluid outlet for allowing a vapor of the substance to exit the cavity. The substance contained within the cavity may be a composition that is suitable for vapor deposition. For example, the substance contained within the cavity may comprise one or more precursors. The substance contained within the cavity may be a homogeneous or heterogenous mixture. The substance contained within the cavity may be in a solid form, a liquid form, a gaseous form, or a combination thereof. The vapor delivery vessel may have a vapor draw configuration, a carrier gas configuration, a double walled configuration, a sublimation configuration, and/or other configuration.

As used herein, a "wet etch rate", abbreviated as "WER", refers to the rate of material loss when said material is exposed to a liquid etchant. For example, the WER may refer to the loss of material from a layer, which may be determined by measuring the decrease in a thickness of the layer as a function of time. In some embodiments, the WER may be measured by exposing the layer to dilute hydrofluoric acid (dHF).

Articles "a" or "an" refer to a species or a genus including multiple species, depending on the context. As such, the terms "a/an", "one or more", and "at least one" can be used interchangeably herein.

The terms "comprising", "including", and "having" are open ended and do not exclude the presence of other elements or components, unless the context clearly indicates otherwise. Comprising, including, and having can be used interchangeably and include the meaning of "consisting of". The phrase "consisting of", however, indicates that no other features or components are present other than those mentioned, unless the context clearly indicates otherwise.

The term "about" as applied to a value generally refers to a range of numbers that is considered to be equivalent to the recited value (e.g., having the same function or result). In some instances, the term "about" may include numbers that are rounded to the nearest significant figure.

The term "essentially" as applied to a composition, a method, a system, or a structure generally means that the additional components do not substantially modify the properties, characteristics, and/or function of the composition, the method, the system, or the structure.

The term "substantially" as applied to a composition, a method, a system, or a structure generally refers to a proportion of a value, a property, a characteristic, or the like, or conversely a lack thereof, that is at least about 70%, or at least about 80%, or at least about 90%, or at least about 95%, or at least about 97%, or at least about 98%, or at least about 99%, or at least about 99.5%, or at least about 99.9%, or more, or any proportion between about 70% and about 100%. In some embodiments, the term "substantially" means a proportion of about 85%, or of about 90%, or about 95%, or about 97%, or about 98%, or about 99%, or about 99.5%, or about 99.9%.

The terms "on" or "over" may be used to describe a relative location relationship. For example, an element, a film, or a layer may be directly positioned on or over and physically contacting at least a portion of another element, film, or layer; or, alternatively, an element, a film, or a layer may be on or over another element, film or layer but have one or more interposed elements, films, or layers therebetween. Therefore, unless the term "directly" is separately used, the terms "on" or "over" will be construed to be a relative concept. Similar to this, it will be understood that the terms "under", "underlying", or "below" describe a relative location relationship and should be construed to be relative concepts unless otherwise indicated.

The terms "at least one", "one or more", and "and/or" are open-ended expressions that are both conjunctive and disjunctive in operation. For example, each of the expressions "at least one of A, B, and C", "at least one of A, B, or C", "one or more of A, B, and C", "one or more of A, B, or C", and "A, B, and/or C" means A alone, B alone, C alone, A and B together, A and C together, B and C together, or A, B, and C together. When each one of A, B, and C in the above expressions refers to an element, such as Q, Y, and Z, or class of elements, such as Q₁-Xₙ, Y₁-Yₘ, and Z₁-Zₒ, the phrase is intended to refer to a single element selected from Q, Y, and Z, a combination of elements selected from the same class (e.g., Q₁ and Q₂) as well as a combination of elements selected from two or more classes (e.g., Y₁ and Z₁).

It should be understood that every numerical range given throughout this disclosure is deemed to include the upper and the lower end points, and each and every narrower numerical range that falls within such broader numerical range, as if such narrower numerical ranges were all expressly written herein. By way of example, the phrase "from about 2 to about 4" or "from 2 to 4" includes 2 and 4 and the whole number and/or integer ranges from about 2 to about 3, from about 3 to about 4, and each possible range based on real (e.g., irrational and/or rational) numbers, such as from about 2.1 to about 3.9, from about 2.1 to about 3.4, and so on.

The standard abbreviations of the elements in the periodic table are used herein.

In certain places throughout the disclosure, a chemical compound, a functional group of a chemical compound, or a substituent or ligand may be referred to by a chemical name (e.g., an IUPAC name or a common name), a molecular formula which may be abbreviated, or both. Additionally, or alternatively, a chemical compound may be shown by a structure which may be provided in stick form or partial stick form and may omit hydrogen atoms. In cases where there is a conflict between the chemical name and/or the molecular formula and/or the structure, and the identity of the chemical compound, the functional group, or the substituent or ligand cannot be unambiguously ascertained by one of skill in the art, then the structure shall prevail, followed by the molecular formula.

In this disclosure, any defined meanings do not necessarily exclude ordinary and customary meanings, in some embodiments.

### Description

Disclosed herein are compositions that are configured for and/or suitable for forming carbon doped silicon containing films. The film forming compositions comprise a silicon precursor having a structure that comprises a 1,3-disilacyclobutane core and at least one substituent group that is bonded to a silicon atom of the 1,3-disilacyclobutane core and that is selected from an acetoxy group, an acryloyloxy group, a C₁ to C₆ alkoxy group, a silyloxy group, a germyloxy group, a phosphonooxy group, and an alkyl amine group. Also disclosed herein are methods for making the film forming compositions and vapor deposition methods and systems for forming carbon doped silicon containing films using said compositions.

As used herein, a carbon doped silicon containing film refers to a film that comprise silicon (Si), oxygen (O), and carbon (C). In some embodiments, the carbon doped silicon containing film comprises one or more other elements, in addition to Si, O, and C, such as nitrogen (N) and/or hydrogen (H). In some embodiments, the carbon doped silicon containing film comprises silicon oxycarbide (SiOC) (which may also be referred to in the literature as silicon carbonoxidee (SiCO)). In some embodiments, the carbon doped silicon containing film consists of, or consists essentially of, silicon oxycarbide (SiOC). In some embodiments, the carbon doped silicon containing film comprises silicon oxycarbonitride (SiOCN). In some embodiments, the carbon doped silicon containing film consists of, or consists essentially of, silicon oxycarbonitride (SiOCN). In some embodiments, the carbon doped silicon containing film comprise Si-C bonds and Si-O bonds and may not comprise Si-N bonds. However, in some other embodiments, the carbon doped silicon containing film comprise Si-C bonds, Si-O bonds, and Si-N bonds. In some embodiments, a ratio of Si-O bonds to Si-C bonds is from about 1:1 to about 10:1. In some embodiments, the carbon doped silicon containing film comprises from about 0.1% to about 70% carbon on an atomic basis. In some embodiments, the carbon doped silicon containing film comprises from about 0.5% to about 60%, or from about 1% to about 50%, or from about 5% to about 50%, or from about 10% to about 50%, or from about 20% to about 50% carbon on an atomic basis. In some embodiments, the carbon doped silicon containing film comprises from about 5% to about 70% oxygen on an atomic basis. In some embodiments, the carbon doped silicon containing film comprises from about 10% to about 70%, or from about 15% to about 50%, or from about 20% to about 40% oxygen on an atomic basis. In some embodiments, the carbon doped silicon containing film comprises from about 5% to about 50% silicon on an atomic basis. In some embodiments, the carbon doped silicon containing film comprises from about 10% to about 50%, or from about 15% to about 40%, or from about 20% to about 35% silicon on an atomic basis. In some embodiments, the carbon doped silicon containing film does not comprise nitrogen. In some other embodiments, the carbon doped silicon containing film comprise from about 0.1% to about 50%, or about 0.1% to about 40%, or about 0.1% to about 30%, or about 0.1% to about 25%, or about 0.1% to about 20%, or about 0.1% to about 15%, or about 0.1% to about 10% nitrogen on an atomic basis. In some embodiments, the carbon doped silicon containing film further comprise hydrogen. In some embodiments, the carbon doped silicon containing film comprises about 0.1% to about 35%, or about 0.1% to about 20%, or about 0.1% to about 15%, or about 0.1% to about 10%, or about 0.1% to about 5 % hydrogen on an atomic basis.

An aspect of the present disclosure relates to film forming compositions that are suitable for forming carbon doped silicon containing films. The film forming compositions comprise a silicon precursor that has a structure that comprises a 1,3-disilacyclobutane core and at least one substituent group that is bonded to a silicon atom of the disilacyclobutane core that is selected from an acetoxy group, an acryloyloxy group, a C₁ to C₆ alkoxy group, a silyloxy group, a germyloxy group, a phosphonooxy group, and an alkylamine group. More specifically, in embodiments, the silicon precursor has a structure according to general Formula (1): 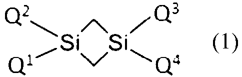 wherein, Q¹ is a substituent that is selected from an acetoxy group, an acryloyloxy group, a C₁-C₆ alkoxy group, a silyloxy group, a germyloxy group, a phosphonooxy group, and an alkylamine group; and Q², Q³, and Q⁴ are each a substituent that is independently selected from a hydrogen atom, a C₁-C₆ alkyl group, an acetoxy group, an acryloyloxy group, a C₁-C₆ alkoxy group, a silyloxy group, a germyloxy group, a phosphonooxy group, and an alkylamine group.

With regard to general Formula (1): An acetoxy group is represented by the chemical formula CH₃C(=O)O. An acryloyloxy group is represented by the chemical formula H₂C=C(R)C(=O)O, where R is a hydrogen atom or an alkyl group, typically a C₁-C₆ alkyl group, more typically a methyl group. Thus, an acryloyloxy group may refer to acryloyloxy (H₂C=CHC(=O)O), methacryloyloxy (H₂C=C(CH₃)C(=O)O), and the like. A C₁-C₆ alkoxy group may have a linear or branched structure and be selected from methoxy (CH₃O), ethoxy (C₂H₅O), iso-propoxy (i-C₃H₇O), n-propoxy (n-C₃H₇O), butoxy (C₄H₉O), pentoxy (C₅H₁₁O), and hexoxy group (C₆H₁₃O), typically selected from methoxy (CH₃O) and ethoxy (C₂H₅O). A silyloxy group is represented by the chemical formula R₃SO, where each R is an independently selected alkyl group, typically a C₁-C₆ alkyl group, more typically a methyl group. A suitable example of a silyloxy group is trimethylsilyloxy ((CH₃)₃SO). A germyloxy group is represented by the chemical formula R₃GeO, where each R is an independently selected alkyl group, typically a C₁-C₆ alkyl group, more typically a methyl group. A suitable example of a germyloxy group is trimethylgermyloxy ((CH₃)₃GeO). A phosphonooxy group is represented by the chemical formula (RO)₂P(=O)O, where each R is an independently selected alkyl group, typically a C₁-C₆ alkyl group, more typically a methyl group. A suitable example of a phosphonooxy group is dimethylphosphonooxy ((CH₃O)₂P(=O)O). An alkyl amine group is represented by the chemical formula NR₂, where each R is an independently selected alkyl group, typically a C₁-C₆ alkyl group. Suitable examples of an alkylamine group are dimethylamine (N(CH₃)₂), diethylamine (N(C₂H₅)₂), di-isopropylamine (N(i-C₃H₇)₂), and the like. A C₁-C₆ alkyl group may have a linear or branched structure and may be selected from methyl (CH₃), ethyl (C₂H₅), propyl (C₃H₇), butyl (C₄H₉), pentyl (C₅H₁₁), and hexyl (C₆H₁₃), typically selected from methyl (CH₃) and ethyl (C₂H₅).

In some embodiments, Q¹ is a substituent that is selected from an acetoxy group, an acryloyloxy group, a C₁-C₆ alkoxy group, a silyloxy group, a germyloxy group, a phosphonooxy group, and an alkylamine group; and Q², Q³, and Q⁴ are each a substituent that is independently selected from a hydrogen atom, a C₁-C₆ alkyl group, and the same substituent group of Q¹. In some of these embodiments, Q¹ and Q³ are the same substituent group (i.e., Q¹ = Q³). Thus, in these embodiments, general Formula (1) may be expressed as: 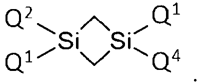 Further, in some of these embodiments, Q¹ and Q³ are the same substituent group, and Q² and Q⁴ are the same substituent group (i.e., Q¹ = Q³ and Q² = Q⁴). Thus, in these embodiments, general Formula (1) may be expressed as:

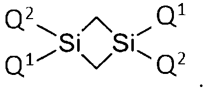

In some embodiments, the silicon precursor has a structure according to general Formula (1), wherein Q¹ and Q³ are dependently selected from the group consisting of an acetoxy group, an acryloyloxy group, a C₁-C₆ alkoxy group, a siloxy group, a germoxy group, a phosphonooxy group, and an alkylamine group; and Q² and Q⁴ are each dependently selected from the group consisting of a hydrogen atom and a C₁-C₆ alkyl group. For example, Q¹ and Q³ each may be an acetoxy group and Q² and Q⁴ each may be dependently selected from a hydrogen atom or a C₁-C₆ alkyl group. In another example, Q¹ and Q³ each may be an acryloyloxy group and Q² and Q⁴ each may be dependently selected from a hydrogen atom or a C₁-C₆ alkyl group. In yet another example, Q¹ and Q³ each may be a C₁-C₆ alkoxy group and Q² and Q⁴ each may be dependently selected from a hydrogen atom or a C₁-C₆ alkyl group. In yet another example, Q¹ and Q³ each may be a silyloxy group and Q² and Q⁴ each may be dependently selected from a hydrogen atom or a C₁-C₆ alkyl group. In yet another example, Q¹ and Q³ each may be a germyloxy group and Q² and Q⁴ each may be dependently selected from a hydrogen atom or a C₁-C₆ alkyl group. In yet another example, Q¹ and Q³ each may be a phosphonooxy group and Q² and Q⁴ each may be dependently selected from a hydrogen atom or a C₁-C₆ alkyl group. In yet another example, Q¹ and Q³ each may be an alkylamine group and Q² and Q⁴ each may be dependently selected from a hydrogen atom or a C₁-C₆ alkyl group.

Suitable examples of silicon precursors having a structure according to general Formula (1) where Q¹ = Q³ and Q² = Q⁴ include those structures shown in Table 1.

**Table 1: Exemplary silicon precursors according to general Formula (1).**

| | |
|---|---|
| 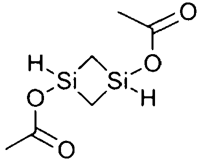 1,3-diacetoxy-1,3-disilacyclobutane | 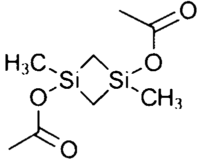 1,3-diacetoxy-1,3-dimethyl-1,3-disilacyclobutane |
| 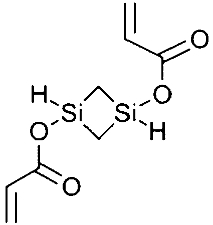 1,3-diacryloyloxy-1,3-disilacyclobutane | 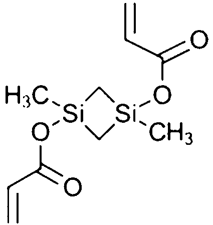 1,3-diacryloyloxy-1,3-dimethyl-1,3-disilacyclobutane |
| 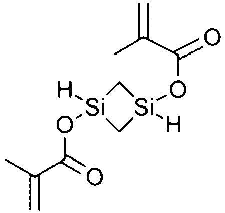 1,3-dimethacryloyloxy-1,3-disilacyclobutane | 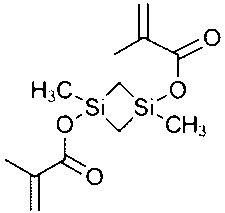 1,3-dimethacryloyloxy - 1,3-dimethyl-1,3-disilacyclobutane |
| 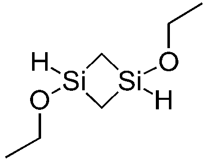 1,3-diethoxy-1,3-disilacyclobutane | 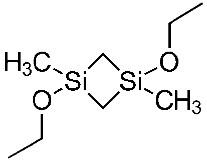 1,3-diethoxy-1,3-dimethyl-1,3-disilacyclobutane |
| 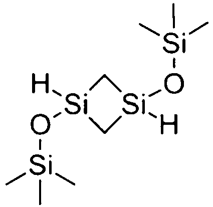 1,3-bis(trimethylsilyloxy)-1,3-disilacyclobutane | 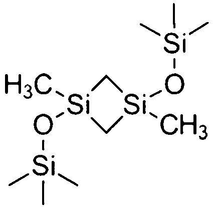 1,3-bis(trimethylsilyloxy)-1,3-dimethyl-1,3-disilacyclobutane |
| 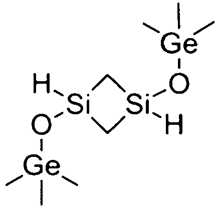 1,3-bis(trimethylgermyloxy)-1,3-disilacyclobutane | 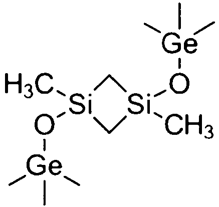 1,3-bis(trimethylgermyloxy)-1,3-dimethyl-1,3-disilacyclobutane |
| 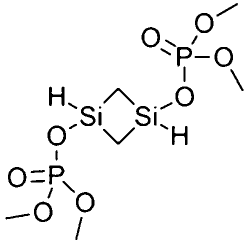 1,3-bis(dimethylphosphonooxy)-1,3-disilacyclobutane | 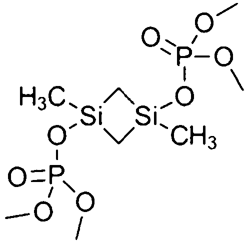 1,3-bis(dimethylphosphonooxy)-1,3-dimethyl-1,3-disilacyclobutane |
| 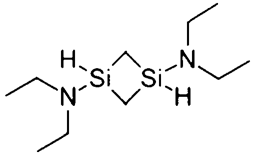 1,3-bis(diethylamine)-1,3-disilacyclobutane | 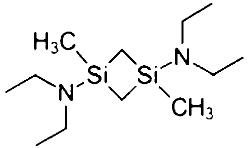 1,3-bis(diethylamine)-1,3-dimethyl-1,3-disilacyclobutane |

In certain embodiments of the disclosure, the silicon precursor shown according to general Formula (1), may comprise both cis and trans isomeric forms. 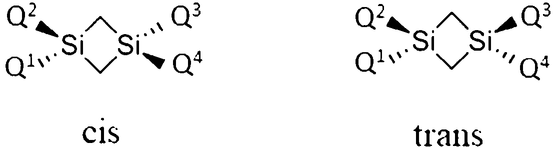 In the cis-isomer form, both of the substituents Q¹ and Q³ are positioned either in the axial position or in the equatorial position of the disilacyclobutane ring. In the trans-isomer form, one of the substituents, Q¹ or Q³, is positioned in axial position, while the other is positioned in the equatorial position of the disilacyclobutane ring. By way of non-limiting example, the silicon precursors shown in Table 1 may be in the cis-isomeric form and the trans-isomeric form. Thus, the film forming composition may comprise a mixture of cis- and trans-isomers. For certain applications, however, it may be desirable to have an isomerically pure or at least an isomerically enriched composition. For example, for thin film deposition applications, isomerically pure (or isomerically enriched) compositions may provide films with less variability in the film structure. Without wishing to be bound by a particular theory, the isomers may interact with the surface of the substrate differently, leading to variation in the film structure. This may be exacerbated if the ratio of the two isomers in the vapor phase varies over time, during the film deposition, due to slight differences in the vapor pressure of the two isomers. In this regard, in some embodiments, the film forming composition comprises a silicon precursor, having a structure according to general Formula (1), that may primarily or may substantially be in the cis-isomer form or in the trans-isomer form. In some of these embodiments, at least about 70% of the silicon precursor is in the cis-isomer form, or at least about 75% of the silicon precursor is in the cis-isomer form, or at least about 80% of the silicon precursor is in the cis-isomer form, or at least about 85% of the silicon precursor is in the cis-isomer form, or at least about 90% of the silicon precursor is in the cis-isomer form, or at least about 95% of the silicon precursor is in the cis-isomer form, or at least about 97% of the silicon precursor is in the cis-isomer form, or at least about 98% of the silicon precursor is in the cis-isomer form, or at least about 99% of the silicon precursor is in the cis-isomer form, or at least about 99.5% of the silicon precursor is in the cis-isomer form. In other words, in some embodiments, a ratio of the cis-isomer to the trans-isomer of the silicon precursor in the film forming composition is at least about 70:30, or at least about 75:25, or at least about 80:20, or at least about 85:15, or at least about 90:10, or at least about 95:5, or at least about 97:3 or at least about 98:2, or at least about 99:1, or at least about 99.5:0.5. In some of these embodiments, the silicon precursor may substantially be or may essentially be in the cis-isomer form. Alternatively, in some of these embodiments, at least about 70% of the silicon precursor is in the trans-isomer form, or at least about 75% of the silicon precursor is in the trans-isomer form, or at least about 80% of the silicon precursor is in the trans-isomer form, or at least about 85% of the silicon precursor is in the trans-isomer form, or at least about 90% of the silicon precursor is in the trans-isomer form, or at least about 95% of the silicon precursor is in the trans-isomer form, or at least about 97% of the silicon precursor is in the trans-isomer form, or at least about 98% of the silicon precursor is in the trans-isomer form, or at least about 99% of the silicon precursor is in the trans-isomer form, or at least about 99.5% of the silicon precursor is in the trans-isomer form. In other words, in some embodiments, a ratio of trans-isomer to cis-isomer of the silicon precursor in the film forming composition is at least about 70:30, or at least about 75:25, or at least about 80:20, or at least about 85:15, or at least about 90:10, or at least about 95:5, or at least about 97:3 or at least about 98:2, or at least about 99:1, or at least about 99.5:0.5. In some of these embodiments, the silicon precursor may substantially be or may essentially be in the trans-isomer form. Such isomerically pure or enriched compositions may beneficially be formed using the methods disclosed herein.

In accordance with certain embodiments of the disclosure, the film forming composition comprising a silicon precursor having a structure according to general Formula (1) can be formed by contacting a halogen substituted 1,3-disilacyclobutane reactant with an organic metal salt (e.g., the metal salt comprises at least one organic group). In some embodiments, a method for forming the film forming composition comprises providing a halogen substituted 1,3-disilacyclobutane reactant that comprises at least one halogen substituent and exchanging the at least one halogen substituent of the halogen substituted 1,3-disilacyclobutane reactant with the substituent group of Q¹ to form the silicon precursor. Example reactions are shown in Equations (1), (2), and (3). 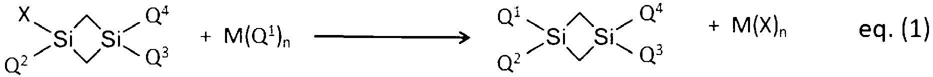 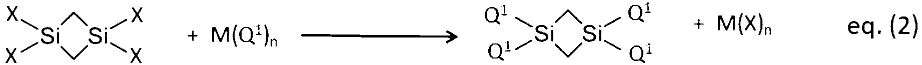 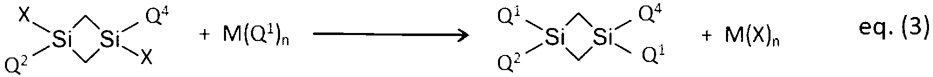 In Equations (1), (2), and (3), X represents a halogen, such as chlorine (Cl), bromine (Br), and iodine (I) and Q¹, Q², Q³, and Q⁴ have the same substituent group assignments as given for general Formula (1) above. The organic metal salt has a structure M(Q¹)ₙ, wherein M is a metal and n is an integer that is typically 1 or 2 depending upon the oxidation state of the metal. In the reaction shown in Equations (1), (2), and (3), the halogen group(s) on the halogen substituted 1,3-disilacyclobutane reactant is/are exchanged for the substituent group of Q¹ to form the silicon precursor and a metal halide salt (M(X)ₙ). The silicon precursor may be separated from the metal halide salt, generally by filtration or decantation.

In some embodiments, the metal (M) of the organic metal salt is selected from a Group I metal or a Group II metal. In some embodiments, M is selected from Li, Na, K, Mg, Ca, Ni, Cu, Al, and Zn. In some embodiments, the organic metal salt is selected from the group consisting of a metal acetate, a metal acrylate, a metal oxide, a metal phosphate, a metal siloxide, a metal germyloxide, and a metal amide. Suitable non-limiting examples of the organic metal salt reactant include lithium acetate (Li(OC(=O)CH₃)), sodium acetate (Na(OC(=O)CH₃)), magnesium acetate (Mg(OC(=O)CH₃)₂), lithium acrylate (Li(OC(=O)CHCH₂)), sodium acrylate (Na(OC(=O)CHCH₂)), magnesium acrylate (Mg(OC(=O)CHCH₂)₂), lithium methacrylate (Li(OC(=O)C(CH₃)CH₂)), magnesium methacrylate (Mg(OC(=O)C(CH₃)CH₂)₂), lithium dimethyl amide (Li(N(CH₃)₂), lithium ethoxide (Li(OCH₂CH₃)), sodium ethoxide (Na(OCH₂CH₃)), magnesium ethoxide (Mg(OCH₂CH₃)₂), lithium dimethyl phosphate (Li(OP(=O)(OCH₃)₂), sodium trimethylsiloxide (Na(OSi(CH₃)₃), and sodium trimethylgermyloxide (Na(OGe(CH₃)₃), each of which is commercially available or may be readily synthesized using known methods reported in the literature.

As shown in Equation (1), in some embodiments, the halogen substituted 1,3-disilacyclobutane reactant is mono-halo substituted and, with reference to general Formula (1), the reaction leads to a silicon precursor where Q¹ is selected from an acetoxy group, an acryloyloxy group, a C₁-C₆ alkoxy group, a silyloxy group, a germyloxy group, a phosphonooxy group, and an alkylamine group; and Q², Q³, and Q⁴ are independently selected from a hydrogen atom or a C₁-C₆ alkyl group. Suitable mono-halo substituted 1,3-disilacyclobutane reactants include 1-chloro-1,3-disilacyclobutane, 1-chloro-1,3,3-trimethyl-1,3-disilacyclobutane, 1-bromo-1,3-disilacyclobutane, 1-bromo-1,3,3-trimethyl-1,3-disilacyclobutane, and the like, each of which are commercially available or may be readily synthesized using known methods reported in the literature.

As shown in Equation (2), in some embodiments, the halogen substituted 1,3-disilacyclobutane reactant is tetra-halo substituted and, with reference to general Formula (1), the reaction leads to a silicon precursor where Q¹, Q², Q³, and Q⁴ are dependently selected from an acetoxy group, an acryloyloxy group, a C₁-C₆ alkoxy group, a silyloxy group, a germyloxy group, a phosphonooxy group, and an alkylamine group (i.e., Q¹ = Q² = Q³= Q⁴). Suitable tetra-halo substituted 1,3-disilacyclobutane reactants include, 1,1,3,3-tetrachloro-1,3-disilacyclobutane, 1,1,3,3-tetrabromo-1,3-disilacyclobutane, and the like, each of which are commercially available or may be readily synthesized using known methods reported in the literature.

As shown in Equation (3), in some embodiments, the halogen substituted 1,3-disilacyclobutane reactant is di-halo substituted and, with reference to general Formula (1), the reaction leads to a silicon precursor where Q¹ and Q³ are dependently selected from an acetoxy group, an acryloyloxy group, a C₁-C₆ alkoxy group, a silyloxy group, a germyloxy group, a phosphonooxy group, and an alkylamine group (i.e., Q¹ = Q³); and Q² and Q⁴ are selected from a hydrogen atom or a C₁-C₆ alkyl group. Suitable di-halo substituted 1,3-disilacyclobutane reactants include, 1,3-dichloro-1,3-disilacyclobutane, 1,3-dichloro-1,3-dimethyl-1,3-disilacyclobutane, 1,3-dibromo-1,3-disilacyclobutane, 1,3-dibromo-1,3-dimethyl-1,3-disilacyclobutane, and the like, each of which are commercially available or may be readily synthesized using known methods reported in the literature. Example silicon precursors that may be formed from the reaction shown in Equation (3) are provided in Table 1. As discussed above, such silicon precursors may be form in the cis-isomer form and in the trans-isomer form, resulting in a mixture of the two isomers, and this may be undesirable for some applications. Accordingly, in some embodiments, the film forming composition comprising a cis/trans isomer mixture may be purified to remove, or at least partially remove, one of the two isomers. Suitable separation methods may include chromatography. Additionally, or alternatively, such silicon precursors may be formed by tailoring the synthetic route to preferentially form either the trans-isomer or the cis-isomer. In this regard, the inventors of the present disclosure have designed synthetic routes for substantially forming the disclosed film forming compositions comprising silicon precursors in trans-isomer form or the cis-isomer form.

In some embodiments of the disclosure, the silicon precursor is preferentially formed in the cis-isomer form or in the trans-isomer form. In some of these embodiments, a ratio of the cis-isomer to the trans-isomer of the silicon precursor in the film forming composition is at least about 70:30, or at least about 75:25, or at least about 80:20, or at least about 85:15, or at least about 90:10, or at least about 95:5, or at least about 97:3 or at least about 98:2, or at least about 99:1, or at least about 99.5:0.5. In some other of these embodiments, a ratio of trans-isomer to cis-isomer of the silicon precursor in the film forming composition is at least about 70:30, or at least about 75:25, or at least about 80:20, or at least about 85:15, or at least about 90:10, or at least about 95:5, or at least about 97:3 or at least about 98:2, or at least about 99:1, or at least about 99.5:0.5. This may be accomplished by forming the halogen substituted 1,3-disilacyclobutane reactant from a stereoisomer enriched 1,3-disilacyclobutane intermediate that is substantially in the cis-isomer form or substantially in the trans-isomer form. Thus, in these embodiments, the method for forming the film forming composition comprises, stereoselectively forming a 1,3-disilacyclobutane intermediate and then reacting the (stereoisomer enriched) 1,3-disilacyclobutane intermediate to form the halogen substituted 1,3-disilacyclobutane reactant. As a result, the halogen substituted 1,3-disilacyclobutane reactant is substantially provided in the cis-isomer form or substantially provided in the trans-isomer form, based on the predominant stereoisomer of the 1,3-disilacyclobutane intermediate. The subsequent reaction step of exchanging the halogen substituents of the halogen substituted 1,3-disilacyclobutane reactant with the substituent group of Q¹ (e.g., as shown in Equation (3)) also substantially forms the corresponding stereoisomer of the silicon precursor.

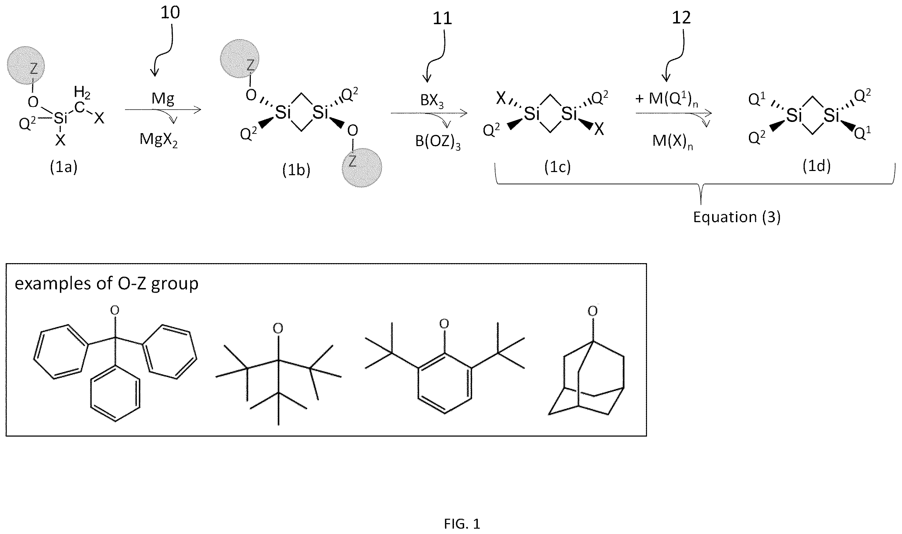

FIG. 1 shows a general reaction sequence to preferentially form the trans-isomer form of the silicon precursor (1d) according to an embodiment of the disclosure. The silicon precursor (1d) has a structure described by general Formula (1), where Q¹=Q³ and Q²=Q⁴. In the reaction sequence, X represents a halogen, such as chlorine (Cl), bromine (Br), and iodine (I), M represents a metal, n is an integer, and Q¹ and Q² have the same substituent group assignments as given in general Formula (1) above. In the first step of the reaction sequence 10, a 1,3-disilacyclobutane intermediate (1b) is formed via a stereoselective ring forming reaction. The halo(halomethyl)oxysilane reactant (1a) comprises a bulky substituent (represented by O-Z) and thus, the ring forming reaction substantially forms the trans-isomer of the 1,3-disilacyclobutane intermediate (1b). The formation of the cis-isomer of the 1,3-disilacyclobutane intermediate (not shown) is sterically unfavorable and, therefore, any formation of cis-isomer form is minor. The selection of the bulky substituent on the halo(halomethyl)oxysilane reactant (1a) may be made in order to minimize or eliminate the formation of the cis-isomer. Example bulky substituent groups include, but are not limited to, a triphenylmethoxy group, a 1,1-bis(1,1-dimethylethyl)-2,2-dimethylpropoxy group, a di-tert-butylphenoxy group, or an adamantoxy group, which are shown in box in FIG. 1. In the next step of the reaction sequence 11, the bulky substituent groups on the 1,3-disilacyclobutane intermediate (1b) are replaced by a halogen atom by reacting the 1,3-disilacyclobutane intermediate (1b) with a halogen exchange reagent such as a boron trihalide (BX₃) (e.g., boron tribromide), an acetyl halide (e.g., acetyl chloride), or the like. The reaction 11 results in the formation of a di-halogen substituted 1,3-disilacyclobutane (1c) that is substantially in the trans-isomer form. In the last step of the reaction sequence 12, the di-halogen substituted 1,3-disilacyclobutane (1c) is reacted with an organic metal salt (M(Q¹)ₙ) to form a silicon precursor (1d) that is also substantially in the trans-isomer form. Notably the reaction 12 to form silicon precursor (1d) from the di-halogen substituted 1,3-disilacyclobutane (1c) corresponds with Equation (3) shown above.

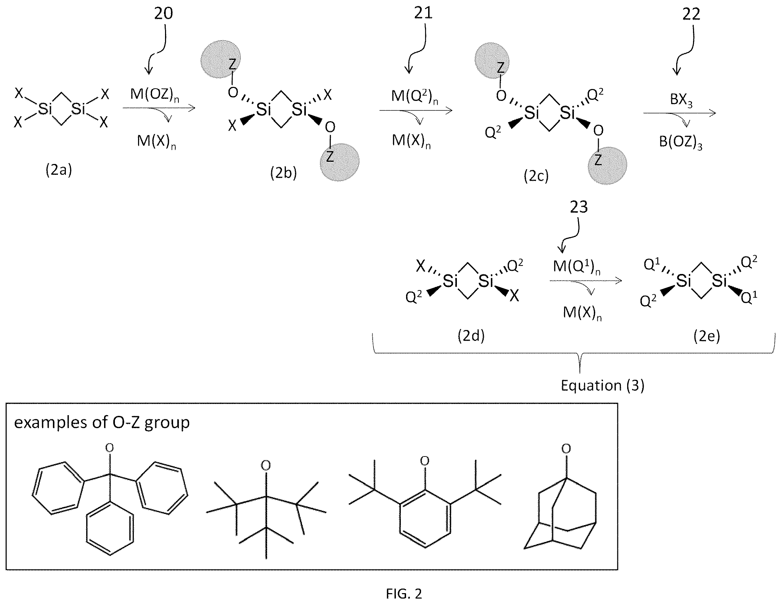

FIG. 2 shows general reaction sequence to preferentially form the trans-isomer form of the silicon precursor (2e) according to another embodiment of the disclosure. In the reaction sequence shown, X represents a halogen, such as chlorine (Cl), bromine (Br), and iodine (I), M represents a metal, n is an integer, and Q¹ and Q² have the same substituent group assignments as given in general Formula (1) above. The silicon precursor (2e) has a structure described by general Formula (1), where Q¹=Q³ and Q²=Q⁴. In the first step of the reaction sequence 20, a first 1,3-disilacyclobutane intermediate (2b) is formed by reacting a 1,1,3,3-tetrahalo-1,3-disilacyclobutane (2a) (e.g., 1,1,3,3-tetrachloro-1,3-disilacyclobutane or 1,1,3,3-tetrabromo-1,3-disilacyclobutane) via a stereo selective exchange reaction. The co-reactant may be a metal salt that comprises a bulky substituent group (represented by M(OZ)ₙ in FIG. 2), that replaces two of the halogen groups on the 1,1,3,3-tetrahalo-1,3-disilacyclobutane (2a). The exchange reaction is stereoselective substantially forming the trans-isomer of the first 1,3-disilacyclobutane intermediate (2b). The formation of the cis-isomer of the first 1,3-disilacyclobutane intermediate (not shown) is sterically unfavorable and, therefore, any formation of cis-isomer form is minor. The selection of the bulky substituent group on the metal salt co-reactant may be made in order to minimize or eliminate the formation of the cis-isomer. Example bulky substituent groups include, but are not limited to, a triphenylmethoxy group, a 1,1-bis(1,1-dimethylethyl)-2,2-dimethylpropoxy group, a di-tert-butylphenoxy group, or an adamantoxy group, which are shown in the box in FIG. 2. In next step 21, the halogen groups on the first 1,3-disilacyclobutane intermediate (2b) are exchanged for hydrogen atoms or C₁-C₆ alkyl groups, generally methyl groups, which are collective represented as Q². Thus, a second 1,3-disilacyclobutane intermediate (2c) is formed from the first 1,3-disilacyclobutane intermediate (2b), wherein the second 1,3-disilacyclobutane intermediate (2c) is also substantially in the trans-isomer form. In the next step 22, the bulky substituent groups may be replaced by reacting second 1,3-disilacyclobutane intermediate (2c) with a halogen exchange reagent such as a boron trihalide (BX₃) (e.g., boron tribromide), an acetyl halide (e.g., acetyl chloride), or the like. The reaction results in the formation of a di-halogen substituted 1,3-disilacyclobutane (2d) that is substantially in the trans-isomer form. In the last step of the reaction sequence 23, the di-halogen substituted 1,3-disilacyclobutane (2d) is reacted with an organic metal salt (M(Q¹)ₙ) to form a silicon precursor (2e) that is also substantially in the trans-isomer form. Notably the reaction 23 to form silicon precursor (2e) from the di-halogen substituted 1,3-disilacyclobutane (2d) corresponds with Equation (3) shown above.

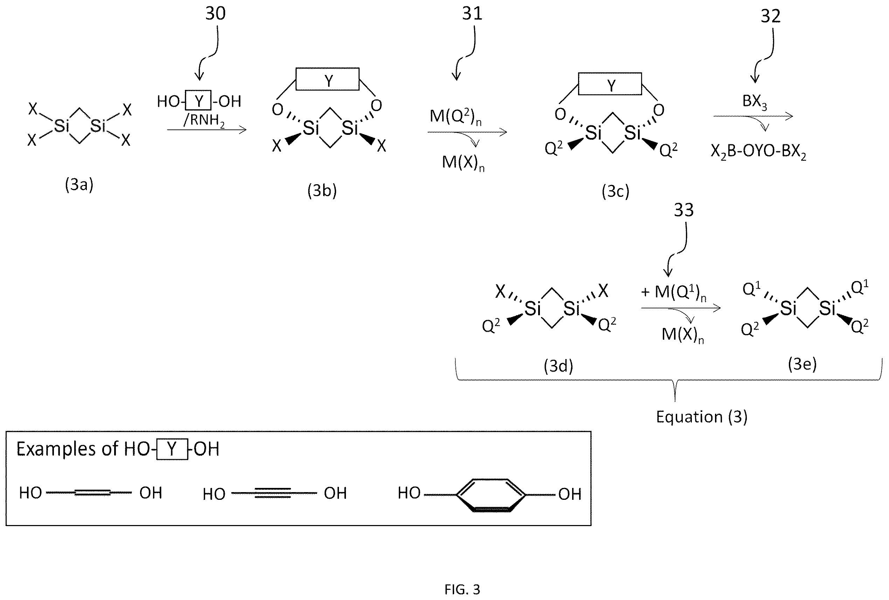

FIG. 3 shows a general reaction sequence to preferentially form the cis-isomer form of the silicon precursor (3e) according to an embodiment of the disclosure. In the reaction sequence, X represents a halogen, such as chlorine (Cl), bromine (Br), and iodine (I), M represents a metal, n is an integer, and Q¹ and Q² have the same substituent group assignments as given in general Formula (1) above. The silicon precursor (3e) has a structure described by general Formula (1), where Q¹=Q³ and Q²=Q⁴. In the first step of the reaction sequence 30, a first 1,3-disilacyclobutane intermediate (3b) is formed by reacting a 1,1,3,3-tetrahalo-1,3-disilacyclobutane (3a) (e.g., 1,1,3,3-tetrachloro-1,3-disilacyclobutane or 1,1,3,3-tetrabromo-1,3-disilacyclobutane) via stereoselective exchange reaction in the presence of a base (e.g., RNH₂ where R is an alkyl group). The co-reactant may be a diol, such as, for example 1,2-ethenediol, 1,2-ethynediol, or hydroquinone, which are shown in the box FIG. 3. The diol co-reactant replaces two of the halogen groups on the 1,1,3,3-tetrahalo-1,3-disilacyclobutane (3a) with a bridged substituent group. The reaction substantially forms the cis-isomer form of 1,3-disilacyclobutane intermediate (3b). Preferably, the reaction should be conducted under dilute conditions to minimize linking of two or more 1,1,3,3-tetrahalo-1,3-disilacyclobutane reactants. The formation of the trans-isomer form of the first 1,3-disilacyclobutane intermediate (not shown) is sterically unfavorable and, therefore, any formation of trans-isomer form is minor. In the next step 31, the halogen groups on the first 1,3-disilacyclobutane intermediate (3b) are exchanged for hydrogen atoms or C₁-C₆ alkyl groups, generally methyl groups, which are collective represented as Q². Thus, a second 1,3-disilacyclobutane intermediate (3c) is formed from the first 1,3-disilacyclobutane intermediate (3b), wherein the second 1,3-disilacyclobutane intermediate (3c) is also substantially in the cis-isomer form. In the next step 32, the bridged substituent group may be replaced by reacting the second 1,3-disilacyclobutane intermediate (3c) with a halogen exchange reagent such as a boron trihalide (BX₃) (e.g., boron tribromide), an acetyl halide (e.g., acetyl chloride), or the like. The reaction results in the formation of a di-halogen substituted 1,3-disilacyclobutane (3d) that is substantially in the cis-isomer form. In the last step of the reaction sequence 33, the di-halogen substituted 1,3-disilacyclobutane (3d) is reacted with an organic metal salt (M(Q¹)ₙ) to form a silicon precursor (3e) that is also substantially in the cis-isomer form. Notably the reaction 33 to form silicon precursor (3e) from the di-halogen substituted 1,3-disilacyclobutane (3d) corresponds with Equation (3) shown above.

Optionally one or more reactions of the method for forming the film forming composition may be performed in an organic solvent such as, for example, pentane, hexane, cyclohexane, benzene, toluene, xylene, diethyl ether, methyl tert-butyl ether, tetrahydrofuran, 1,4-dioxane, acetonitrile, triethyl amine, pyridine, ethyl acetate, acetone, 1,2-dimethoxyethane, dimethyl sulfoxide, 2-butanone, methylene chloride, and mixtures thereof. The various reactions may be performed at a reduced temperature, at room temperature (~ 18-25 °C), or at an elevated temperature. For example, in some embodiments, one or more reaction may be performed at a reduced temperature that is above the freezing point of the solvent, if a solvent is used, or typically at least about -80°C up to about 17°C. Additionally, or alternatively, in some embodiments, one or more reactions may be performed at about room temperature. Additionally, or alternatively, in some embodiments, one or more reactions may be performed at an elevated temperature that is up to the boiling point of the solvent, if a solvent is used, or typically from about 26 °C up to about 200°C. The temperature of individual reactions may be varied to optimize the product distribution and yield.

The film forming composition may be purified using standard methods. The film forming composition disclosed herein may comprise one or more impurities, which may be the result of trace elements in the raw material sources, residual reactants and solvents and reaction byproducts from the synthetic method, and/or decomposition products, among other things. The film forming compositions may be purified, for example using distillation or sublimation, as applicable, extraction, and/or contacting the composition with a sorbent, among other methods. In some embodiments, the film forming composition comprises at least about 90 wt % of the silicon precursor, or at least about 95 wt % of the silicon precursor, or at least about 97 wt % of the silicon precursor, or at least about 98 wt % of the silicon precursor, or at least about 99 wt % of the silicon precursor, or at least about 99.5 wt % of the silicon precursor, or at least about 99.9 wt % of the silicon precursor, or at least about 99.99 wt % of the silicon precursor. In some embodiments, the film forming compositions consists of or consists essentially of the silicon precursor. In some embodiments, an amount of impurities in the film forming composition is less than about 5 wt %, or less than about 2 wt %, or less than about 1 wt %, or less than about 0.5 wt %, or less than about 0.1 wt %, or less than about 0.05 wt %, or less than about 0.01 wt %. In some embodiments, an amount of halogen containing impurities in the film forming compositions is no more than about 5%, or no more than about 4%, or no more than about 3%, or no more than about 2%, or no more than about 1%, or no more than about 0.5%, or no more than about 0.1%, or no more than about 100 ppm, or no more than about 10 ppm. In some embodiments, an amount of metal impurities in the film forming compositions is no more than about 1%, or no more than about 0.5%, or no more than about 0.1%, or no more than about 100 ppm, or no more than about 10 ppm, or no more than about 1 ppm, or no more than about 100 ppb, or no more than about 10 ppb. In some embodiments, an amount of carbon containing impurities in the film forming compositions is no more than about 5%, or no more than about 4%, or no more than about 3%, or no more than about 2%, or no more than about 1%, or no more than about 0.5%, or no more than about 0.1%, or no more than about 100 ppm, or no more than about 10 ppm. In some embodiments, an amount of silicon containing impurities in the film forming compositions is no more than about 5%, or no more than about 4%, or no more than about 3%, or no more than about 2%, or no more than about 1%, or no more than about 0.5%, or no more than about 0.1%, or no more than about 100 ppm, or no more than about 10 ppm. In certain other embodiments, an amount of germanium containing impurities in the film forming compositions is no more than about 5%, or no more than about 4%, or no more than about 3%, or no more than about 2%, or no more than about 1%, or no more than about 0.5%, or no more than about 0.1%, or no more than about 100 ppm, or no more than about 10 ppm. In certain other embodiments, an amount of phosphorous containing impurities in the film forming compositions is no more than about 5%, or no more than about 4%, or no more than about 3%, or no more than about 2%, or no more than about 1%, or no more than about 0.1%, or no more than about 100 ppm, or no more than about 10 ppm. In certain other embodiments, an amount of nitrogen containing impurities in the film forming compositions is no more than about 5%, or no more than about 4%, or no more than about 3%, or no more than about 2%, or no more than about 1%, or no more than about 0.5%, or no more than about 0.1%, or no more than about 100 ppm, or no more than about 10 ppm.

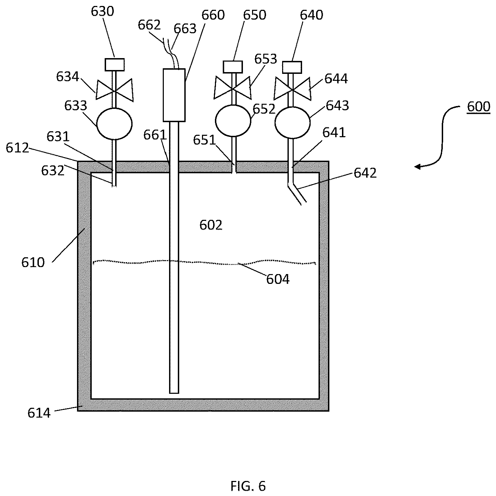

In some embodiments of the disclosure, the film forming composition is provided in a vapor delivery vessel. The vapor delivery vessel is configured to store the film forming composition and to provide a vapor flow of the film forming composition from the vapor delivery vessel to an external environment, for example, to a substrate processing system or a semiconductor processing apparatus for forming a carbon doped silicon containing film. The vapor delivery vessel is generally formed from a material that is non-reactive to the film forming composition and, in some embodiments, may also be compliant with U.S. Department of Transportation (DOT) regulation, such as 49 C.F.R. § 178 (2021). In some embodiments, the vapor delivery vessel is formed from stainless steel (e.g., 316, 316L, 304, or 304L alloys). The configuration of the vapor delivery vessel may vary in different embodiments of the disclosure, depending upon the melting point and volatility of the silicon precursor as well as other factors. The vapor delivery vessel, however, generally comprises an outer wall that encloses a cavity for storing the film forming composition and a gas outlet for allowing a vapor of the film forming composition to exit the cavity. The gas outlet is seated in the outer wall of the vapor delivery vessel and is in communication with the cavity of the vapor delivery vessel and has at least one valve positioned thereon to fluidly couple or decouple the cavity to the outside environment. In some embodiments, the vapor delivery vessel comprises one or more other fluid inlets or outlets, in addition to the gas outlet. For example, the vapor delivery vessel may comprise a fluid inlet that is seated in the outer wall of the vapor delivery vessel and is in communication with the cavity of the vapor delivery vessel and having at least one valve positioned thereon for filling the vapor delivery vessel with the film forming composition. Additionally, or alternatively, the vapor delivery vessel may comprise a fluid inlet that is seated in the outer wall of the vapor delivery vessel and is in communication with the cavity of the vapor delivery vessel and having at least one valve positioned thereon for flowing a carrier gas into the cavity of the vessel, either over the surface of the film forming composition and/or through the film forming composition. Some or all of the one or more valves provided on the various inlets and outlets may be rated for high temperature (e.g., typically up to 100°C, or up to 150°C, or up to 200°C, or up to 250°C) to withstand the temperatures that may be required to provide sufficient vapor pressure and prevent condensation of the film forming composition within the values and other components. In some embodiments, the vapor delivery vessel further comprises one or more probe members, that may comprise one or more temperature sensors, and/or one or more pressure sensors, and/or one or more level sensors. A variety of level sensors for measuring the amount of the film forming composition within the cavity of the vapor delivery vessel are known in the art, including, but not limited to, capacitive-based sensors, conductivity-based sensors, float switch level sensors, tuning fork sensors, and ultrasonic sensors. In some embodiments, the vapor delivery vessel further comprises one or more heat transfer elements, such as, for example, fins, rods, beads, and the like, to facilitate heat transfer from the walls of the vessel to the film forming composition within the cavity, or vice versa. The one or more heat transfer elements may form a serpentine or radial path for holding the film forming composition within the cavity and, in some cases, for directing the flow of a carrier gas over or through the film forming composition. Such configurations are particularly useful for delivering a vapor of low-volatility liquids and solid compositions. The various design features described above may be combined, as appropriate, to optimize the vapor flow of the film forming composition from the vapor delivery vessel. An example of a suitable vapor delivery vessel is shown in FIG. 6, which is discussed in detail below.

Another aspect of the present disclosure relates to vapor deposition methods for forming a carbon-doped silicon containing film using the film forming compositions comprising the silicon precursor disclosed herein. Suitable vapor deposition methods include ALD or CVD, including plasma-enhanced, radical-enhanced, and thermal methods. The methods generally comprise providing a substrate in a reaction space (e.g., one or more reaction chambers), introducing a vapor of the film forming composition to the reaction space, and exposing a surface of the substrate to the silicon precursor. The step of exposing the surface of the substrate to the silicon precursor composition results in the formation of an adsorbed silicon precursor containing layer on the surface of the substrate. The adsorbed silicon precursor containing layer may be physiosorbed and/or chemisorbed on the surface of the substrate and may be a full or partial monolayer on the surface or multiple mono-layers. The adsorbed silicon precursor containing layer may comprise the intact silicon precursor, and/or a portion or fragment of the silicon precursor. In some embodiments, a conversion step is employed to convert the adsorbed silicon precursor containing layer to a targeted carbon doped silicon containing layer. In some embodiments, the surface of the substrate is additionally exposed a co-reactant to form the targeted carbon doped silicon containing layer. In some embodiments, the surface of the substrate is additionally exposed a plasma to form the targeted carbon doped silicon containing layer. In some embodiments, the method for forming a carbon-doped silicon containing film comprises providing a substrate in a reaction space and performing one or more deposition cycles of a cyclic deposition process. The cyclic deposition process can include one or more of an ALD process and a cyclic CVD process.

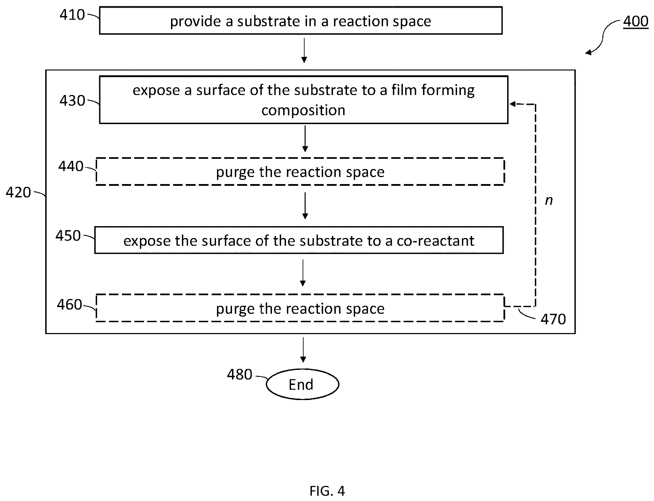

FIG. 4 shows a process flow diagram 400 of an exemplary embodiment for forming a carbon-doped silicon containing film using a cyclic deposition process. The method comprises providing a substrate in a reaction space 410 and executing one or more deposition cycles of a cyclic deposition process 420, comprising: exposing a surface of the substrate to the film forming composition that comprises the silicon precursor (described above) 430 to form an adsorbed silicon precursor containing layer on the surface of the substrate; optionally purging the reaction space 440; exposing the surface of the substrate to a co-reactant 450, thereby forming a carbon-doped silicon containing film on the surface of the substrate; and optionally purging the reaction space 460. (Alternatively, the surface of substrate may be exposed to the co-reactant, then to the film forming composition.) Steps 430 and 450, with optional steps 440 and 460, make up one deposition cycle. The method may comprise repeating 470 the deposition cycle one or more (n) times in a cyclic deposition process 420 to increase the uniformity and/or the thickness of the carbon-doped silicon containing film on the surface of the substrate. The cyclic deposition process 420 may be terminated 480 once the desired uniformity and/or thickness of the carbon-doped silicon containing film has been reached.

In step 410, a substrate is provided to a reaction space. A substrate loading/unloading mechanism is generally employed to insert the substrate into the reaction space, and to optionally transfer the substrate between various reaction chambers of the reaction space in embodiments where multiple reaction chambers are employed. The substrate is not particularly limited and is generally described above. In some embodiments, the substrate is a semiconductor wafer or multiple semiconductor wafers. For example, the substrate may be a silicon wafer, such as a monocrystalline silicon wafer (e.g., a p-type monocrystalline silicon wafer). Alternatively, the substrate may comprise silicon-germanium (SiGe), monocrystalline germanium, gallium arsenide, etc. The substrate may comprise one or more material layers such as dielectric layers, insulating layers, metal layers, certain nitrides, sacrificial layers, and so forth, present from one or more previous manufacturing steps. In some embodiments, the substrate comprises a hydroxyl-terminated surface and this can advantageously improve the deposition method described herein. The substrate may include various topological features or structures, such as gaps, recesses, lines, trenches, vias, holes, or spaces between elevated portions formed within or on at least a portion of a layer of the substrate.

The reaction space is not particularly limited and may comprise one or more reaction chambers of a semiconductor processing system. In some embodiments, the semiconductor processing system is a cluster tool. In some embodiments, a reaction chamber or reaction chambers in a flow-type reactor may be utilized. In some embodiments, a reaction chamber or reaction chambers in a showerhead-type reactor may be utilized. In some embodiments, a reaction chamber or reaction chambers in a space divided reactor may be utilized. In some embodiments, a reaction chamber or reaction chambers in a high-volume manufacturing-capable single wafer reactor may be utilized. In other embodiments, a reaction chamber or reaction chambers in a batch reactor may be utilized. For embodiments in which a batch reactor is used, the reaction chamber may house a number of wafers, for example, the number of wafers may be in the range of 10 to 200, or 50 to 150, or even 100 to 150.

In the methods disclosed herein, the surface of the substrate is exposed to the film forming composition (described above) 430, resulting in the formation of an adsorbed silicon precursor containing layer on the surface of the substrate. Exposing the surface of the substrate to the film forming composition 430 may comprise introducing a vapor of the film forming composition into the reaction space and contacting the surface of the substrate with the vapor of the film forming composition. The film forming composition is generally provided from a vapor delivery vessel that comprises the film forming composition and that is connected to and in fluid communication with the reaction space, typically through one or more gas lines, valves, and flow controllers. The vapor delivery vessel and the one or more gas lines, valves, and flow controllers may be heated to facilitate the flow of the film forming composition from the vapor delivery vessel, through the one or more gas lines, valves, and flow controllers into the reaction space. The vapor pressure of silicon precursor in the film forming composition will depend upon the specific structure of the silicon precursor and the temperature of the vapor delivery vessel may be adjusted (i.e., heated or cooled) to provide sufficient vapor pressure (typically about 1-20 torr at temperature ranging from 25 °C to 200 °C) to facilitate delivery of the film forming composition to the reaction space. In some embodiments, a neat flow the film forming composition vapor flows from the vapor delivery vessel through the one or more gas lines, valves, and flow controllers into the reaction space. In other embodiments, the film forming composition vapor may be entrained in a flow of an inert carrier gas (e.g., nitrogen and/or a noble gas such as helium (He) and argon (Ar)) and introduced into the reaction space.

In some embodiments, the step of exposing the surface of the substrate to the film forming composition 430 includes pulsing the film forming composition into the reaction space, over the substrate surface. In embodiments, where the film forming composition is pulsed over the surface of the substrate, the pulse time may be between about 0.01 second and about 60 seconds, or from about 0.1 second to about 30 seconds, or from about 1 second to about 10 seconds. During the pulsing, the flow rate of the film forming composition may be less than about 2000 sccm, or less than about 1000 sccm, or less than about 500 sccm, or less than about 100 sccm. The flow rate may be, for example, about 500 sccm to about 1200 sccm, such as about 600 sccm, or about 800 sccm, or about 1000 sccm. The pulse time may vary according to film forming composition in question, the reaction chamber configuration, and other process parameters (e.g., temperature, pressure, substrate, etc.) which may be independently selected to optimize the process.

A conversion step may be employed to convert the adsorbed silicon precursor containing layer to a targeted carbon doped silicon containing film. For example, the surface of the substrate may be further exposed to a co-reactant 450. In some embodiments, the surface of the substrate is exposed to a plasma species to form the targeted carbon doped silicon containing film. In some embodiments, the surface of the substrate is exposed to one or more of a hydrogen plasma, a noble gas plasma, a nitrogen plasma, and an oxygen plasma. The co-reactant may comprise one or more excited and/or radical species that may be formed in situ in the reaction space using a direct plasma formed near the vicinity or directly above the substrate (e.g., a direct plasma). Alternatively, the co-reactant comprising one or more excited and/or radical species may be formed using a remote plasma, either in situ in the reaction space in a location that is spatially separated from the substrate or upstream of the reaction space (e.g., a remote plasma). A remote plasma may be used to minimize or avoid exposing the surface of the substrate to energetic ionic species. In either case, the plasma may be formed using a feed gas comprising one or more of an inert gas and a reactive gas. The feed gas is fed into a plasma unit and the plasma discharged is activated. In some embodiments, the feed gas is fed into the reaction space and the plasma discharged is pulsed (i.e., turned on and off). The power for generating the plasma can be varied in different embodiments of the disclosure. In some embodiments, the power for generating the plasma is from about 10 W to about 2,000 W, typically from about 20 W to about 1,000 W, or from about 20 W to about 500 W, or from about 20 W to about 200 W, or from about 20 W to about 100 W.

In some embodiments, the surface of the substrate is exposed to one or more of a hydrogen plasma and a noble gas plasma. In some of these embodiments, the feed gas comprises hydrogen (H₂) and/or a noble gas selected from the group consisting of helium (He), neon (Ne), argon (Ar), krypton (Kr), xenon (Xe), and mixtures thereof. In some embodiments, the co-reactant comprises a hydrogen plasma species. In some embodiments, the surface of the substrate is exposed to a hydrogen plasma. Additionally, or alternatively, in some embodiments, the co-reactant comprises a noble gas plasma species. In some embodiments, the surface of the substrate is exposed to a noble gas plasma. In these embodiments, the plasma may be used to activate the adsorbed silicon precursor containing layer on the substrate surface and may not necessarily contribute material to the deposited film but can, in some circumstances, contribute to film growth. In some embodiments, the reactive gas may comprise a noble gas and H₂, where the noble gas and H₂ are provided at a flow ratio from about 20:1 to about 1:20, or from about 10:1 to about 1:10, or from about 5:1 to about 1:5, or from about 1:2 to about 2:1, or about 1:1.

In some embodiments, the surface of the substrate is exposed to a nitrogen plasma. In certain embodiments, the co-reactant comprises a nitrogen plasma species. In these cases the feed gas may comprise a reactive gas comprising one or more of nitrogen (N₂), a N₂/H₂ mixture, ammonia (NH₃), an alkyl amino (NR₃, where each R is independently an H, an alkyl group, or an aryl group), hydrazine (N₂H₄), and a substituted hydrazine; hence, the co-reactant may comprise one or more of N₂, NH₃, an alkyl amino, hydrazine N₂H₄, a substituted hydrazine, as applicable, as well as excited species, radical species, and plasma species formed therefrom. In some embodiments, the co-reactant comprises a nitrogen plasma species, for example, the co-reactant may comprise one or more of activated nitrogen (N₂), activated ammonia (NH₃), nitrogen atoms (N), NH and NH₂ radicals, and other N-H containing species created in the plasma discharge. In some embodiments, the reactive gas may comprise N₂ and H₂, where the N₂ and H₂ are provided at a flow ratio (N₂:H₂) from about 20:1 to about 1:20, or from about 10:1 to about 1:10, or from about 5:1 to about 1:5, or from about 1:2 to about 2:1, or about 1:1.

In some embodiments, the surface of the substrate is exposed to an oxygen plasma. In certain embodiments, the co-reactant may comprise an oxygen plasma species. In some embodiments, the reactive gas comprises one or more of oxygen (O₂), ozone (O₃), water (H₂O), hydrogen peroxide (H₂O₂), an organic peroxide, an alcohol, nitrogen dioxide (NO₂), nitrous oxide (N₂O), and nitric oxide (NO); hence, the co-reactant may comprise one or more of oxygen (O₂), ozone (O₃), water (H₂O), hydrogen peroxide (H₂O₂), an organic peroxide, an alcohol, nitrogen dioxide (NO₂), nitrous oxide (N₂O), and nitric oxide (NO), as applicable, as well as excited species, radical species, and plasma species formed therefrom. In some embodiments, the oxygen co-reactant comprises an oxygen plasma species, for example, the oxygen co-reactant may comprise one or more of atomic oxygen (O), excited diatomic oxygen (e.g., singlet oxygen (¹O₂)), ozone (O₃), hydroxyl radical (OH), peroxyl radical (e.g., HO₂), and nitric oxide (NO). In some other embodiments, the co-reactant is free or substantially free of oxygen plasma species. In certain embodiments, the substrate is not exposed to an oxygen plasma. Thus, the resulting film may comprise a higher carbon content and thus may have a lower dielectric constant. Additionally, or alternatively, in certain embodiments, damage to sublayers on the substrate surface (e.g., a conductive interlayer(s)) by an oxygen plasma may be prevented. Therefore, accordingly, a low electric performance of the resulting device may be prevented.

In some embodiments, the step of exposing the surface of the substrate to the co-reactant 450 comprises pulsing the co-reactant into the reaction space over the substrate surface. Pulsing may be achieved by controlling the flow of the feed gas into the reaction space and activating the plasma discharge that is used to form the co-reactant. In embodiments where the co-reactant is pulsed over the substrate, the pulse time may be between about 0.01 second and about 60 seconds, or from about 0.1 second to about 30 seconds, or from about 1 second to about 10 seconds. During the pulsing, the flow rate of the feed gas may be less than about 2000 sccm, or less than about 1000 sccm, or less than about 500 sccm, or less than about 100 sccm. The flow rate may be, for example, about 500 sccm to about 1200 sccm, such as about 600 sccm, or about 800 sccm, or about 1000 sccm. The pulse time may vary according to co-reactant in question, the reaction chamber configuration, and other process parameters (e.g., temperature, pressure, substrate, etc.) which may be independently selected to optimize the process according to the application in question.

In some embodiments, the step of exposing the surface of the substrate to the film forming composition 430 and the step of exposing the surface of the substrate to the co-reactant 450 at least partially at overlap. For instance, in embodiments where the film forming composition and/or the co-reactant are pulsed over the substrate, the film forming composition pulse and the co-reactant pulse may at least partially overlap. In some embodiments, the introduction of the film forming composition and the introduction of the co-reactant into the reaction space may be simultaneous. In some embodiments, the introduction of the film forming composition and the co-reactant into the reaction space may be at least partially separate. For instance, in embodiments where the film forming composition and the co-reactant are pulsed over the substrate surface, the film forming composition pulse and the co-reactant pulse may at least be partially separated. In some embodiments, the introduction of the film forming composition and the co-reactant into the reaction space may be completely separate. For instance, in embodiments where the film forming composition and the co-reactant are pulsed over the substrate surface, the film forming composition pulse and the co-reactant pulse may be completely separate.

In some embodiments, the reaction space is purged between the exposing of the surface of the substrate to the film forming composition 430 and the exposing of the surface of the substrate to the co-reactant 450. For example, optional purging steps are shown in 440 and 460 in FIG. 4. Purging may be affected between two pulses of gases which react with each other. Purging may also be affected between two pulses of gases that do not react with each other. For example, a purge or purging may be provided between pulses of the film forming composition and the co-reactant. Purging may avoid or at least reduce gas-phase interactions between the two gases reacting with each other. It shall be understood that a purge can be affected either in time or in space, or both. For example, in the case of temporal purges, a purge step can be used, for example, in a temporal sequence of providing a first reactant to a reaction space, providing a purge gas to the reaction space, and providing a second reactant to the reaction space, wherein the substrate on which a layer is deposited does not move. For example, in the case of spatial purges, a purge step can comprise moving a substrate from a first location to which a first reactant is continually supplied (e.g., a first reaction chamber), through a purge gas curtain, to a second location to which a second reactant is continually supplied (e.g., a second reaction chamber).

The various process steps may be repeated 470 one or more times to grow a carbon doped silicon containing film on the surface of the substrate. The number of repeated cycles *(n)* is not particularly limited and depends on the growth per-cycle (GPC) and the targeted thickness the film. Typically, the film thickness may range from several angstroms to several hundred microns. The number of repeated cycles (n) may be between 1 and about 1,000, typically between 1 and about 500, or between 1 and about 200, or between 1 and about 100, or between 1 and about 50, or between 1 and about 10. The GPC of the carbon doped silicon film may at least about 0.01 Å /cycle to no more than about 10 Å/cycle. In certain embodiments, the GPC may vary depending upon the exposure time of the substrate surface to the film forming composition. In some embodiments, the GPC of the carbon doped silicon film is at least about 0.05 Å /cycle to no more than about 10 Å /cycle, or at least about 0.05 Å /cycle to no more than about 8 Å /cycle, or at least about 0.05 Å /cycle to no more than about 7 Å /cycle, or at least about 0.05 Å /cycle to no more than about 6 Å /cycle , or at least about 0.05 Å /cycle to no more than about 5 Å /cycle, or at least about 0.05 Å /cycle to no more than about 4 Å /cycle, or at least about 0.05 Å /cycle to no more than about 3 Å /cycle, or at least about 0.05 Å /cycle to no more than about 2.5 Å /cycle, or at least about 0.05 Å /cycle to no more than about 2.0 Å /cycle, or at least about 0.05 Å /cycle to no more than about 1.5 Å /cycle, or at least about 0.05 Å/cycle to no more than about 1 Å/cycle, or at least about 0.05 Å/cycle to no more than about 0.5 Å/cycle, or at least about 0.1 Å /cycle to no more than about 5 Å /cycle, or at least about 0.1 Å /cycle to no more than about 4 Å /cycle, or at least about 0.1 Å /cycle to no more than about 3 Å /cycle, or at least about 0.1 Å /cycle to no more than about 2.5 Å /cycle, or at least about 0.1 Å /cycle to no more than about 2.0 Å /cycle, or at least about 0.1 Å /cycle to no more than about 1.5 Å /cycle, or at least about 0.1 Å/cycle to no more than about 1 Å/cycle, or at least about 0.5 Å /cycle to no more than about 5 Å /cycle, or at least about 0.5 Å /cycle to no more than about 4 Å /cycle, or at least about 0.5 Å /cycle to no more than about 3 Å /cycle, or at least about 0.5 Å /cycle to no more than about 2.5 Å /cycle, or at least about 0.5 Å /cycle to no more than about 2.0 Å /cycle, or at least about 0.5 Å /cycle to no more than about 1.5 Å /cycle. In some embodiments, the GPC of the carbon doped silicon containing film is about 0.5 Å /cycle or more, or about 1 Å /cycle or more, or about 1.5 Å /cycle or more, or about 2 Å /cycle or more. In some embodiments, the GPC of carbon doped silicon containing film is about 0.5 Å /cycle, or about 1 Å /cycle, or about 1.5 Å /cycle, or about 2 Å /cycle, or about 2.5 Å /cycle, or about 3 Å /cycle, or about 3.5 Å /cycle, or about 4 Å /cycle, or about 4.5 Å /cycle, or about 5 Å /cycle, or about 5.5 Å /cycle, or about 6 Å /cycle, or about 6.5 Å /cycle, or about 7 Å /cycle. Typically for ALD processes the GPC is between about 0.1 Å /cycle and about 3 Å /cycle, whereas the GPC for cyclic CVD processes can be higher depending upon the exposure time of the substrate to the film forming composition.

The method may further comprise, maintaining a temperature of the substrate at a set temperature during the cyclic deposition process 420. In some embodiments, the method comprises maintaining a temperature of the substrate at a set temperature during one or both of the exposing steps (e.g., 430 and 450 in FIG. 4). In some embodiments, the method comprises maintaining the substrate temperature at about room temperature. In other embodiments, the method further comprises heating the substrate to a temperature of at least about 40 °C to no more than about 500 °C. In some embodiments, the method comprises maintaining the substrate temperature from about 25 °C to about 500 °C, typically from about 100 °C to about 450 °C, or from about 100 °C to about 425 °C, or from about 100 °C to about 400 °C, or from about 100 °C to about 375 °C, or from about 100 °C to about 350 °C, or from about 100 °C to about 325 °C, or from about 100 °C to about 300 °C, or from about 100 °C to about 275 °C, or from about 100 °C to about 250 °C, or from about 200 °C to about 450 °C, or from about 200 °C to about 425 °C, or from about 200 °C to about 400 °C, or from about 200 °C to about 375 °C, or from about 200 °C to about 350 °C. In some embodiments, the method is performed while maintaining the substrate at a temperature of less than about 450 °C, or less than about 425 °C, or less than about 400 °C, or less than about 375 °C, or less than about 350 °C, or less than about 325 °C, or less than about 300 °C, or less than about 275 °C, or less than about 250 °C, or less than about 225 °C, or less than about 200 °C, or less than about 175 °C, or less than about 150 °C. In some embodiments, the method comprises maintaining the substrate temperature at about 25 °C, or at about 50 °C, or at about 75 °C, or at about 100 °C, or at about 125 °C, or at about 150 °C, or at about 175 °C, or at about 200 °C, or at about 225 °C, or at about 250 °C, or at about 275 °C, or at about 300 °C, or at about 325 °C, or at about 350 °C, or at about 375 °C, or at about 400 °C, or at about 425 °C, or at about 450 °C.

In addition to controlling the temperature of the substrate, the methods of the present disclosure may be performed in a reduced pressure environment. In some embodiments, the method further comprises controlling a pressure inside of the reaction space during the cyclic deposition process 420. The pressure within the reaction space may be between about 1 mTorr and about 760 Torr, or between about 0.5 Torr and about 30 Torr, such as about 10 Torr, or about 15 Torr, or about 20 Torr. In some embodiments, a pressure within the reaction space during the cyclic deposition process 420 is less than about 500 Torr, or a pressure within the reaction chamber during the cyclic deposition process 420 is between about 0.1 Torr and about 500 Torr, or between about 1 Torr and about 100 Torr, or between about 1 Torr and about 20 Torr. In some embodiments, a pressure within the reaction space during the cyclic deposition process 420 is less than about 300 Torr, less than about 100 Torr, less than about 50 Torr, or less than about 10 Torr.

Another aspect of the present disclosure is related to systems for forming a carbon doped silicon containing film using the film forming compositions and methods disclosed herein. In some embodiments, the systems may comprise a semiconductor processing system that comprises a reaction space (e.g., one or more reaction chambers) for accommodating a substrate. The semiconductor processing system may comprise one reaction chamber, two reaction chambers, three reaction chambers, four reaction chambers, or more. In some embodiments, the semiconductor processing system is a cluster tool. In some embodiments, a reaction chamber or reaction chambers in a flow-type reactor may be utilized. In some embodiments, a reaction chamber or reaction chambers in a showerhead-type reactor may be utilized. In some embodiments, a reaction chamber or reaction chambers in a space divided reactor may be utilized. In some embodiments, a reaction chamber or reaction chambers in a high-volume manufacturing-capable single wafer reactor may be utilized. In other embodiments, a reaction chamber or reaction chambers in a batch reactor may be utilized. The semiconductor processing system further comprises a source of the film forming composition and a means for exposing the surface of the substrate to a vapor of the film forming composition disclosed herein. The semiconductor processing system may further comprise a means for exposing the substrate the co-reactant and optionally a means for purging the reaction space between the exposing steps.

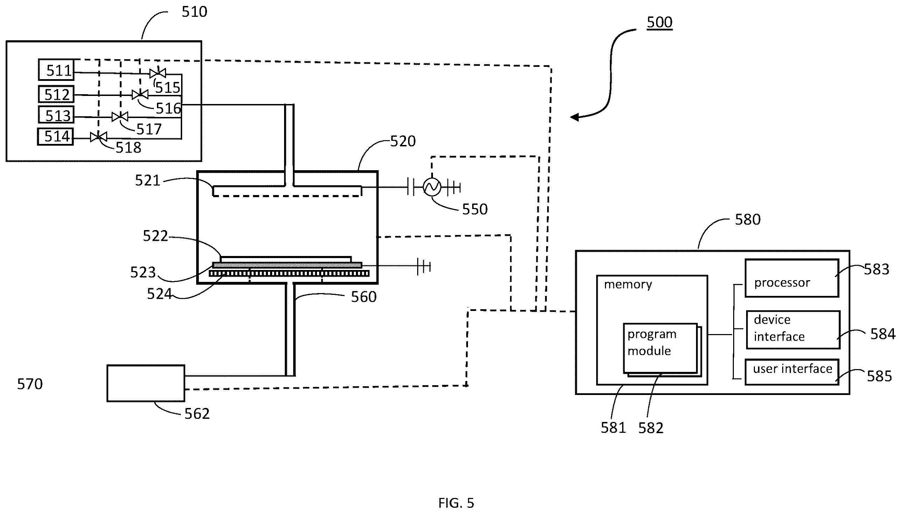

FIG. 5 shows an exemplary embodiment of a semiconductor processing system 500 according to the present disclosure. The film forming composition disclosed herein and other gasses are provided into a reaction chamber 520 through an injector assembly 510. The injector assembly 510 is configured to provide a vapor of the film forming composition from a film forming composition source 511 that is coupled to the reaction chamber 520 via a first valve 515. The injector assembly 510 may be further configured to provide one or more other gasses, such as one or more co-reactants or feed gasses to form the one or more co-reactants from a co-reactant source 512 that is coupled to the reaction chamber 520 via a second valve 516, and/or one or more carrier gasses (e.g., nitrogen and/or a noble gas, such as He, Ne, Ar, Kr, Xe, and combinations thereof) from a carrier gas source 513 coupled to the reaction chamber 520 via a third valve 517. The injector assembly 510 may further comprise one or more other gas sources 514, for example coupled to the reaction chamber 520 via a forth valve 518, for providing purge gases, additional carrier gases, make-up gasses, etc., and a means for heating (not shown) the various sources (511-514) and the corresponding valves (515-518) and gas lines, if required, to facilitate the introduction of the film forming composition and other reactants into the reaction chamber 520.

In some embodiments, the film forming composition source 511 comprises a vapor delivery vessel that comprises the film forming composition. FIG. 6 shows a perspective view of an exemplary embodiment of a vapor delivery vessel 600 according to the disclosure. The vapor delivery vessel 600 comprises an outer wall that may generally be in the shape of a cylinder, having a bottom portion 614 and a top portion 612 that are connected by a cylindrical body 610 to enclose a cavity 602 for storing the film forming composition 604 within. The vapor delivery vessel 600 further comprises a gas outlet 651, an optional gas inlet 631, an optional fluid inlet 641, and an optional probe member 660. The gas outlet 651 is seated on the top portion of the outer wall 612 and is in communication with the cavity 602. The gas outlet 651 is configured for providing a vapor of the film forming composition from the cavity 602. In this regard, the gas outlet 651 may comprise one or more valves for opening and closing the gas outlet and for controlling the flow of the vaporized film forming composition from the cavity 602. For example, the gas outlet 651 may have one or both of a manual valve 653 and an actuated valve 652 arranged on the exterior of the vessel 600 along the gas outlet 651. The gas inlet 631 may also be seated in the top portion of the outer wall 612 and is in communication with the cavity 602. The gas inlet 631 may be configured for flowing a carrier gas into the cavity 602, either over the surface of the film forming composition 604 or through the film forming composition 604 to entrain the vapor of the film forming composition in the carrier gas flow exiting the gas outlet 651. In this regard, the gas inlet 631 may have a conduit that extends into cavity to a fixed point 632 that is either above the surface of the film forming composition as shown in FIG. 6 or, alternatively, below the surface film forming composition (not shown). Further, in this regard, the gas inlet 631 may have one or more valves for opening and closing the gas inlet 631 and for controlling the flow of the carrier gas into the cavity 602. For example, the gas inlet 631 may have one or both of a manual valve 634 and an actuated valve 633 arranged on the exterior of the vessel 600 along the gas inlet 631. The fluid inlet 641 may also be seated in the top portion of the outer wall 612 and is in communication with the cavity 602. The fluid inlet 641 may be configured for refilling the vapor delivery vessel 600 with film forming composition 604. In this regard, the fluid inlet 641 may have a conduit 642 that extends into the cavity 602 and may, in certain embodiments, be bent towards the out wall 610 to reduce splashing, frothing, and/or fluctuations in the level film forming composition during refilling. Further, in this regard, the fluid inlet 641 may have one or more valve for opening and closing the fluid inlet 641 and for controlling the flow of the film forming composition 604 into the cavity 602. For example, the fluid inlet 641 may have one or both of a manual valve 644 and an actuated valve 643 arranged on the exterior of the vessel 600 along the fluid inlet 641. The probe member 660 may be seated in the top portion 612 of the outer wall and extends into the cavity 602 toward the bottom portion 614. In certain examples, the probe member 660 may be removably fixed within a probe member aperture 661 so that the probe member 660 may be removed for cleaning and/or replacement as needed. The probe member 660 may contain one or more temperature sensors 662 and/or one or more level sensors 663. The one or more temperature sensors 662 and/or one or more level sensors 663 of the probe member 660 and the various actuated valves (633, 652, and 643) may each be configured so that they can be operably associate with the controller 580 (see FIG. 5). Further, the vapor delivery vessel 600 may be removably connected to the injector assembly 510 (see FIG. 5) via one or more optional connectors, shown in 630, 650, and 640, so that the vapor delivery vessel 600 can be disconnected from the injector assembly 510 (see FIG. 5) for cleaning and filing with the film forming composition in a located that is remote from the semiconductor processing system 500 (see FIG. 5). Although the vapor delivery vessel 600 is shown and described herein as having a specific arrangement, it is to be understood and appreciated that the vapor delivery vessel may include other elements and/or exclude certain elements described herein, or have another arrangement, and remain within the scope of the present disclosure. For example, the vapor delivery vessel may comprise other arrangements of inlets and outlets, including having fewer or additional inlets and outlets, or other arrangements of values including having fewer or additional valves.

Referring back to FIG. 5, the film forming composition and other gasses flow into the reaction chamber 520 through a showerhead 521 that is positioned directly above a susceptor 523 on which a substrate 522 is placed. In some embodiments, the reaction chamber 520 further comprises one or more heating elements 524 that are in thermal communication with the substrate 522 and one or more thermocouples (not shown) to measure and maintain a temperature of the substrate at a set temperature. Unreacted gasses and gaseous reaction by-products are removed from the reaction chamber 520 through an exhaust line 560 coupled to an external environment 570 via one or more optional vacuum pumps 562. A plasma generator 550 (e.g., a RF plasma generator, microwave plasma generator, capacitively coupled plasma generator, or inductively coupled plasma generator) may be electrically connected to the showerhead 521, allowing for the showerhead 521 to be biased relative to the susceptor 523 to form a plasma discharge between the two. Optionally, an ion trap (not shown) may be positioned between the showerhead 521 and the substrate 522 to restrict the plasma to the upper portion of the reaction chamber 520, above the ion trap to reduce the interaction of ionic species with the substrate surface. For example, an electrically grounded mesh plate may be used as an ion trap.

The semiconductor processing system also comprises a controller 580. The controller 580 generally includes a device interface 584, a processor 583, a user interface 585, and a memory 581. The device interface 584 connects the processor 583 via a wired or wireless link to various components of the vapor delivery vessel (e.g., one or more of 633, 652, 643, 662, and 663 in FIG. 6) and one or more of the injector assembly 510, the reaction chamber 520, the plasma discharge 550, the exhaust source 560, and/or and other components such as, one or more heating elements 524 and thermal couples (not shown) for controlling the temperature of the substrate 522. The processor 583 is in turn operably connected to the user interface 585, for example, to receive a user input and/or provide a user output and is in communication with the memory 581. The memory 581 may include a non-transitory machine-readable medium having a plurality of program modules 582 recorded thereon that, when read by the processor 583, cause the processor 583 to execute certain operations. Among the operations are operations of a method for depositing a carbon-doped silicon containing film (e.g., 400, see FIG. 4) using the film forming composition described above.

In some embodiments, the controller 580 is configured and programed to perform a first operation and a second operation, among other things. In the first operation, the controller 580 opens the first valve 515 to flow a vapor of the film forming composition from the film forming composition source 511 into the reaction chamber 520, thereby exposing the surface of the substrate to the film forming composition and, after a set period of time, the controller 580 closes the first valve 515 to the film forming composition source 511. In the second operation, the controller 580 opens the second valve 516 to flow the co-reactant or co-reactant feed gas from the co-reactant source 512 into the reaction chamber 520 and pulse (turn on, then off) the plasma generator 550, thereby exposing the surface of the substrate 522 to the co-reactant. After another set period of time, the controller 580 closes the second valve 516 to the co-reactant source 512. In certain embodiment, the controller 580 is programed to perform the first operation and the second operation, or vice versa, wherein at least a portion of the first operation overlaps with at least a portion of the second operation such that the flow of the film forming composition into the reaction chamber 520 at least partially overlaps with the flow of the co-reactant into the reaction chamber 520. In certain other embodiments, the controller 580 is programed to sequentially perform the first operation followed by the second operation, or vice versa, such that the flow of the film forming composition into the reaction chamber 520 and the flow of the co-reactant into the reaction chamber 520 do not overlap. The controller 580 may be programed to repeat the first operation and the second operation (n times) to grow a carbon doped silicon containing film on the surface of the substrate 522.

As will be appreciated by one of skill in art, the controller 580 may be configured and programed to perform other operations. For example, the controller 580 may be operably connected to a purge gas source 514 and configured and programed to open the fourth valve 518 to the purge gas source 514 to flow a purge gas into the reaction chamber 520 and, after a set period of time, close the fourth valve 518 to the purge gas source 514. In another example, the controller 580 may be operably connected to one or more heating elements 524 and one or more thermocouples (not shown) and configured and programed to measure and control a temperature of the at least one heating element 524 to maintain a temperature of the substrate 522 at a set temperature.

Further, as will be appreciated by one of skill in art, other semiconductor deposition systems configurations are possible. For example, although the injection assembly 510 and reaction chamber 520 are shown and described herein as having a specific structure and flow configuration, other flow configurations and/or other mechanisms for providing the various reactants and gases and for housing the substrate and flowing gasses over the substrate may be utilized. Additionally, other plasma generation configurations may be utilized. In some embodiments, a remote plasma unit that is positioned upstream of the reaction chamber 520 may be used to generate a remote plasma. Additionally, although the controller 580 is shown and described herein as having a specific architecture, it is to be understood and appreciated that other controller architectures may be employed and remain within the scope of the present disclosure.

Another aspect of the present disclosure relates to carbon-doped silicon containing layers or films formed using the film forming compositions disclosed herein. Further, the carbon-doped silicon containing layers or films may be formed using the method and the system described herein. In some embodiments, a carbon-doped silicon film formed by contacting a surface of a substrate with the film forming composition disclosed herein is provided. In some of these embodiments, the carbon-doped silicon film comprises the silicon precursor and/or a portion or fragment of the silicon precursor. The silicon precursor and/or a portion or fragment of the silicon precursor may be adsorbed to the surface of the substrate. In some embodiments, a carbon doped silicon containing film formed by the method described in FIG. 4 is provided. In some embodiments, a carbon doped silicon containing film formed by contacting a surface of a substrate with the film forming composition disclosed herein and one or more of a hydrogen plasma, a noble gas plasma, a nitrogen plasma, and an oxygen plasma is provided.

The disclosed film forming compositions and the methods and systems for using said film forming compositions to form a carbon doped silicon containing film may provide several benefits. In particular, the film forming compositions may provide a carbon doped silicon containing film having a high carbon content, generally between about 1 % and 70%, typically between about 5% and about 50%, or between about 10% and about 50%, or between about 20% and about 50%. While not wishing to be bound by a particular theory, the high carbon content of the film may be due to the Si-C-Si linkages in the silicon precursor structure, and in certain embodiments the presence of CH₃-Si bonds. Additionally, or alternatively, in certain embodiments, the method for forming a carbon-doped silicon containing film, excludes exposing the substrate to an oxygen plasma. Rather, a hydrogen plasma and/or a noble gas plasma may be used to form the carbon doped silicon containing film, while still maintaining an acceptable GPC and/or throughput. As a result, in certain embodiments, the carbon doped silicon containing film may have a desirable low dielectric constant. For example, in some embodiments, the carbon doped silicon containing film has a dielectric constant of less than about 4.2, or less than about 4.0, or less than about 3.8, or less than about 3.5, or less than about 3.4, or less than about 3.3, or less than about 3.2, or less than about 3.1, or less than about 3.0, or less than about 2.9, or less than about 2.8, or less than about 2.7, or less than about 2.6, or less than about 2.5, or less than about 2.4, or less than about 2.3, or less than about 2.2, or less than about 2.1, or less than about 2.0. Further, in some embodiments, the carbon doped silicon containing film may also have good mechanical performance. For example, in some embodiments, the carbon doped silicon containing film may have a wet etch rate (WER) of less than 2.5 nm/min in 0.5% dilute hydrofluoric acid, or less than 2.0 nm/min in 0.5% dilute hydrofluoric acid, or less than 1.5 nm/min in 0.5% dilute hydrofluoric acid, or less than 1.0 nm/min in 0.5% dilute hydrofluoric acid, or less than 0.5 nm/min in 0.5% dilute hydrofluoric acid. Further, in some embodiments, the carbon doped silicon containing film may also have good conformality. For example, in some embodiments, the carbon doped silicon containing film has a step coverage of about 80% or more, or about 90% or more. In some embodiments, the carbon doped silicon containing film has a step coverage of about 90% more and less than about 110%, or about 95% or more and less than about 105%.

Although certain embodiments and examples are disclosed herein, it will be understood by those skilled in the art that the disclosed compositions, methods, and systems, extend beyond the specifically disclosed embodiments and include all novel and nonobvious combinations and sub-combinations of the various compositions, methods, and systems, as well as any and all equivalents thereof. It is to be understood that the compositions, methods, and systems described herein are exemplary in nature, and that these specific embodiments or examples are not to be considered in a limiting sense, because numerous variations are possible. The specific methods and systems described herein may represent one or more of any number of processing strategies. Thus, the various acts illustrated may be performed in the sequence illustrated, in other sequences, or omitted in some cases. Moreover, various features of the disclosure are grouped together in one or more, aspects, embodiments, and configurations for the purpose of streamlining the disclosure. The features of the aspects, embodiments, and configurations of the disclosure may be combined in alternate aspects, embodiments, and configurations other than those discussed above. The compositions, methods, and systems of the disclosure are not to be interpreted as reflecting an intention that the claimed disclosure requires more features than are expressly recited in each claim. Rather, as the following claims reflect, inventive aspects lie in less than all features of a single foregoing disclosed aspects, embodiments, and configurations. Thus, the following claims are hereby incorporated into this Detailed Description, with each claim standing on its own as a separate embodiment of the disclosure, and the features recited in the various dependent claims may be combined with one another in various combinations, as appropriate, to form other embodiment of the disclosure.

## Claims

1. A film forming composition comprising a silicon precursor having a structure according to general Formula (1): 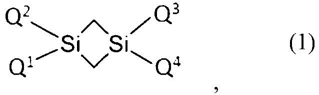 wherein Q¹ is a substituent selected from the group consisting of an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent independently selected from the group consisting of a hydrogen atom, a C₁-C₆ alkyl group, and the same substituent group of Q¹.

2. The film forming composition of claim 1, wherein the substituent group of Q¹ is selected from the group consisting of an acetoxy group, an acryloyloxy group, a silyloxy group, a germyloxy group, and a phosphonooxy group.

3. The film forming composition of claim 1, wherein the substituent groups Q¹ and Q³ are dependently selected from the group consisting of an acetoxy group, an acryloyloxy group, a C₁ to C₆ alkoxy group, a silyloxy group, a germyloxy group, a phosphonooxy group, and an alkyl amine group; and the substituent groups Q² and Q⁴ are dependently selected from the group consisting of a hydrogen atom and a C₁-C₆ alkyl group, and wherein at least 85% of the silicon precursor is in the cis-isomer form or at least 85% of the silicon precursor is in the trans-isomer form.

4. The film forming composition of claim 1, wherein the silicon precursor is selected from the group consisting of 1,3-diacetoxy-1,3-disilacyclobutane, 1,3-diacetoxy-1,3-dimethyl-1,3-disilacyclobutane, 1,3-diacryloyloxy-1,3-disilacyclobutane, 1,3-diacryloyloxy-1,3-dimethyl-1,3-disilacyclobutane, 1,3-dimethyacryloyloxy-1,3-disilacyclobutane, 1,3-dimethyacryloyloxy-1,3-dimethyl-1,3-disilacyclobutane, 1,3-bis(trimethylsilyloxy)-1,3-disilacyclobutane, 1,3-bis(trimethylsilyloxy)-1,3-dimethyl-1,3-disilacyclobutane, 1,3-bis(trimethylgermyloxy)-1,3-disilacyclobutane, 1,3-bis(trimethylgermyloxy)-1,3-dimethyl-1,3-disilacyclobutane, 1,3-bis(dimethylphosphonooxy)-1,3-disilacyclobutane, and 1,3-bis(dimethylphosphonooxy)-1,3-dimethyl-1,3-disilacyclobutane.

5. The film forming composition of any one of claims 1-4, wherein the film forming composition has a purity of at least about 97 wt. %.

6. A vapor delivery vessel comprising a film forming composition comprising a silicon precursor having a structure according to general Formula (1): 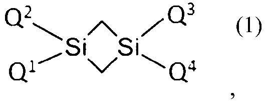 wherein Q¹ is a substituent selected from the group consisting of an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent independently selected from the group consisting of a hydrogen atom, a C₁-C₆ alkyl group, and the same substituent group of Q¹.

7. A method for forming a film forming composition comprising a silicon precursor having a structure according to general Formula (1): 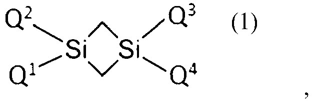 wherein Q¹ is a substituent selected from the group consisting of an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent independently selected from the group consisting of a hydrogen atom, a C₁-C₆ alkyl group, and the same substituent group of Q¹,
the method comprising:
providing a halogen substituted 1,3-disilacyclobutane reactant comprising at least one halogen substituent; and
exchanging the at least one halogen substituent of the halogen substituted 1,3-disilacyclobutane reactant with the substituent group of Q¹ to form the silicon precursor.

8. The method of claim 7, wherein the step of exchanging the at least one halogen substituent of the halogen substituted 1,3-disilacyclobutane reactant comprises contacting the halogen substituted 1,3-disilacyclobutane reactant with an organic metal salt having a general structure of M(Q¹)ₙ to form the silicon precursor and a metal halide salt, wherein (i) M is a Group I metal and n is an integer equal to 1 or (ii) M is a Group II metal and n is an integer equal to 2, and wherein the method further comprises separating the silicon precursor from the metal halide salt.

9. The method of claim 7, wherein the halogen substituted 1,3-disilacyclobutane reactant is selected from the group consisting of 1-chloro-1,3-disilacyclobutane, 1-chloro-1,3,3-trimethyl-1,3-disilacyclobutane, 1,3-dichloro-1,3-disilacyclobutane, 1,3-dichloro-1,3-dimethyl-1,3-disilacyclobutane, 1,1,3,3-tetrachloro-1,3-disilacyclobutane, 1-bromo-1,3-disilacyclobutane, 1-bromo-1,3,3-trimethyl-1,3-disilacyclobutane, 1,3-dibromo-1,3-disilacyclobutane, 1,3-dibromo-1,3-dimethyl-1,3-disilacyclobutane, and 1,1,3,3-tetrabromo-1,3-disilacyclobutane.

10. The method of claim 7, wherein the substituent group of Q¹ is selected from the group consisting of an acetoxy group, an acryloyloxy group, a silyloxy group, a germyloxy group, and a phosphonooxy group.

11. The method of claim 7, wherein the substituent groups of Q¹ and Q³ are dependently selected from the group consisting of an acetoxy group, an acryloyloxy group, a C₁ to C₆ alkoxy group, a silyloxy group, a germyloxy group, a phosphonooxy group, and an alkyl amine group; and the substituent groups of Q² and Q⁴ are dependently selected from the group consisting of a hydrogen atom and a C₁-C₆ alkyl group and wherein at least 85% of the silicon precursor is in the cis-isomer form or at least 85% of the silicon precursor is in the trans-isomer form.

12. The method of claim 11, wherein the step of providing the halogen substituted 1,3-disilacyclobutane reactant comprises:
stereoselectively forming a 1,3-disilacyclobutane intermediate; and
reacting the 1,3-disilacyclobutane intermediate to form the halogen substituted 1,3-disilacyclobutane reactant.

13. The method of claim 12, wherein the 1,3-disilacyclobutane intermediate is a second 1,3-disilacyclobutane intermediate, wherein the method further comprises:
stereoselectively forming a first 1,3-disilacyclobutane intermediate; and
forming the second 1,3-disilacyclobutane intermediate from the first 1,3-disilacyclobutane intermediate.

14. A method for depositing a carbon doped silicon containing film, the method comprising:
providing a substrate in a reaction space;
exposing a surface of the substrate to a vapor of a film forming composition comprising a silicon precursor having a structure according to general Formula (1): 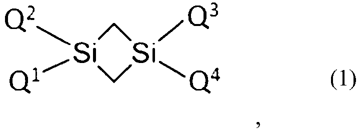 wherein Q¹ is a substituent group selected from the group consisting of an acetoxy group, an acryloyloxy group, a C₁ to C₆ alkoxy group, a silyloxy group, a germyloxy group, a phosphonooxy group, and an alkyl amine group; and Q², Q³, and Q⁴ are each a substituent group independently selected from the group consisting of a hydrogen atom, a C₁-C₆ alkyl group, and the same substituent group of Q¹.

15. The method of claim 14, wherein, in the general Formula (1), the substituent group of Q¹ is selected from the group consisting of an acetoxy group, an acryloyloxy group, a silyloxy group, a germyloxy group, and a phosphonooxy group.

16. The method of claim 14, wherein, in the general Formula (1), the substituent groups of Q¹ and Q³ are dependently selected from the group consisting of a C₁ to C₆ alkoxy group, an acetoxy group, an acryloyloxy group, a silyloxy group, a germyloxy group, a phosphonooxy group, and an alkyl amine group; and the substituent groups of Q² and Q⁴ are dependently selected from the group consisting of a hydrogen atom and a C₁-C₆ alkyl group, wherein at least 85% of the silicon precursor is in the cis-isomer form or at least 85% of the silicon precursor is in the trans-isomer form.

17. The method of claim 14, wherein the silicon precursor is selected from the group consisting of 1,3-diacetoxy-1,3-disilacyclobutane, 1,3-diacetoxy-1,3-dimethyl-1,3-disilacyclobutane, 1,3-diacryloyloxy-1,3-disilacyclobutane, 1,3-diacryloyloxy-1,3-dimethyl-1,3-disilacyclobutane, 1,3-dimethyacryloyloxy-1,3-disilacyclobutane, 1,3-dimethyacryloyloxy-1,3-dimethyl-1,3-disilacyclobutane, 1,3-bis(trimethylsilyloxy)-1,3-disilacyclobutane, 1,3-bis(trimethylsilyloxy)-1,3-dimethyl-1,3-disilacyclobutane, 1,3-bis(trimethylgermyloxy)-1,3-disilacyclobutane, 1,3-bis(trimethylgermyloxy)-1,3-dimethyl-1,3-disilacyclobutane, 1,3-bis(dimethylphosphonooxy)-1,3-disilacyclobutane, and 1,3-bis(dimethylphosphonooxy)-1,3-dimethyl-1,3-disilacyclobutane.

18. The method of claim 14, wherein the method further comprises: exposing the surface of the substrate to a co-reactant, wherein the co-reactant is one or more of a hydrogen plasma, a noble gas plasma, a nitrogen plasma, and an oxygen plasma.

19. The method of claim 18, wherein the co-reactant is one or more of a hydrogen plasma and a noble gas plasma and wherein the co-reactant is free of an oxygen plasma species.

20. The method of claim 18, wherein the steps of exposing the surface of the substrate with the vapor of the film forming composition and exposing the surface of the substrate to the co-reactant occurs sequentially.

21. The method of claim 18, wherein the steps of exposing the surface of the substrate with the vapor of the film forming composition and exposing the surface of the substrate to the co-reactant at least partially overlap.
